(19) Europäisches Patentamt
European Patent Office
Office européen des brevets

(11) EP 0 344 646 B1

(12) **EUROPEAN PATENT SPECIFICATION**

(45) Date of publication and mention
of the grant of the patent:
**30.09.1998 Bulletin 1998/40**

(51) Int Cl.6: **H01J 37/317**, H01J 37/30,
H01J 37/304

(21) Application number: **89109553.1**

(22) Date of filing: **26.05.1989**

(54) **Ion beam lithography**

Ionenstrahllithographie

Lithographie par faisceaux d'ions

(84) Designated Contracting States:
**AT BE DE FR GB IT NL SE**

(30) Priority: **01.06.1988 EP 88890133**
**02.06.1988 US 201959**
**29.07.1988 US 226275**

(43) Date of publication of application:
**06.12.1989 Bulletin 1989/49**

(73) Proprietors:
• **IMS Ionen Mikrofabrikations Systeme**
**Gesellschaft m.b.H.**
**A-1020 Wien (AT)**
• **Österreichische Investitionskredit**
**Aktiengesellschaft**
**1013 Wien (AT)**

(72) Inventors:
• **Stengl, Gerhard, Dr.**
**A-9241 Wernberg Kärnten (AT)**
• **Glavish, Hilton F., Dr.**
**Nevada 89450 (US)**

(74) Representative: **Matschnig, Franz, Dipl.-Ing.**
**Patentanwalt,**
**Siebensterngasse 54,**
**Postfach 252**
**1071 Wien (AT)**

(56) References cited:
**EP-A- 294 363**         **EP-A- 0 281 549**

• **NUCLEAR INSTRUMENTS & METHODS IN**
**PHYSICS RESEARCH, vol. 191, nos. 1-3,**
**December 1981, pages 157-168, North-Holland**
**Publishing Co., Amsterdam, NL; W.L. BROWN et**
**al.: "Ion beam lithography"**
• **JOURNAL OF VACUUM SCIENCE &**
**TECHNOLOGY, vol. 16, no. 6,**
**November/December 1979, pages 1883-1885,**
**Am. Vacuum Society; G. STENGL et al.: "Ion**
**projection system for IC production"**
• **JOURNAL OF VACUUM SCIENCE &**
**TECHNOLOGY B, vol. 4, no. 1, January/February**
**1986, pages 194-200, second series, New York,**
**US; G. STENGL et al.: "Ion projection lithography**
**machine IPLM-01: A new tool for sub-0.5-micron**
**modification of materials**
• **TECHN. PROC. SEMICON/WEST 1986, pages**
**42-52, SEMI, Montain View, CA, US; G. STENGL**
**et al.: "Sub-0.1-mum iom projection lithography"**
• **P. GRIVET: "Electron optics", 1965, pages**
**183-203, Pergamon Press, Oxford**
• **JOURNAL OF PHYSICS E: SCIENTIFIC**
**INSTRUMENTS, vol. 16, 1983, pages 387-389,**
**Bristol, GB; M.S. MICHAIL: "An efficient**
**technique of characterising calibration grids in**
**e-beam lithography tools"**

**EP 0 344 646 B1**

**Description**

This invention relates to ion beam projection lithography for manufacturing of semiconductor devices and the like.

Of the various processes required to manufacture semiconductor devices, lithography is a highly important step. Simply described, the lithography process begins by coating a silicon wafer with a thin photosensitive material called photo-resist, or simply "resist". A lithographic exposure tool projects an image of a pattern contained on a mask or reticle onto the resist-coated wafer. The wafer is stepped through a series of exposure positions by which the same pattern or the mask is exposed a number of times on the wafer. Development leaves a resist pattern that delineates the desired images on the wafer surface. The wafer is then subjected to any one of many possible processes such as etching, oxidation, ion implanting, diffusion, and deposition. After processing the wafer is inspected, recoated with resist and the cycle is repeated from 8 to 15 times resulting in a checker-board array of identical microcircuits on the wafer.

Most projection lithography to date has employed a beam of light for exposure of the wafer, but the demand for smaller feature size and higher density of components has led to a search for higher degrees of precision. A great effort has been spent on seeking to provide X-ray lithographic systems, while other systems, including ion beam projection lithography have received some, but considerably less attention.

Journal of Vacuum Science and Technology B, Vol. 4, No. 1, Jan./Feb. 1986, pages 194-200, G. Stengl et al.: "Ion projection lithography machine IPLM-01: A new tool for sub-0.5-micron modification materials" discloses an ion projection lithography apparatus comprising means to provide an ion beam, a mask in the path of the ion beam with apertures for producing a desired beam pattern, an optical column after said mask, the column defined by first and second principal lenses located along the ion path, the first lens being arranged to focus the ion beam and being an accelerating lens, the second lens being positioned after the first lens and being arranged to project a reduced image of the mask, and a target station after the second lens for supporting a target that receives the image.

One principal aim of the invention is to overcome what has appeared to be limitations and drawbacks of prior proposals for ion beam projection lithography. Another aim is to provide to industry an overall practical ion lithographic system suitable for commercial use and especially capable of forming very small features in overlayed patterns on a wafer.

## SUMMARY OF THE INVENTION

According to one aspect of the invention, an ion projection lithography apparatus is provided comprising means to provide an ion beam, a mask in the path of the ion beam with apertures for producing a desired beam pattern, an optical column after the mask, the column being defined by first and second principal lenses located along the ion path, the first lens being arranged to form said ion beam and being an accelerating Einzel lens (i.e. an Einzel lens configured to first accelerate, then decelerate the ions) arranged to form a crossover within the column, the second lens being positioned after the crossover of said first lens and being a gap lens, arranged to project a reduced image of the mask, and a target station after the second lens for supporting a target that receives the image.

Preferred embodiments of this aspect of the invention have the following features. The mask is located substantially at the first focal plane of the first lens and the target station is located substantially at the second focal plane of the second lens. The means to provide the ion beam comprises an ion source and means to provide to the optical column a virtual image of the ion source more distant from the column than the ion source and the distances (1) between the second focal plane of the first lens and the first focal plane of the second lens, and (2) between the mask and a point defining the virtual image of the source, being selected to produce the image of the mask at the target with chromatic blurring and geometrical distortion, arising from the lenses, simultaneously substantially minimized. The lenses are positioned to locate the crossover of the first lens substantially at the first focal plane of the second lens to produce a substantially telecentric beam following the second lens.

In a particularly preferred embodiment of the invention, the lens system simultaneously satisfies substantially the following conditions whereby the beam emerging from the second lens is substantially telecentric and at the image plane is substantially free of chromatic blurring and geometrical distortion:

$$(1) \qquad qp = f_1\, f_2$$

$$(2) \qquad \frac{(\delta_1/f_1)}{\left(\delta'_1/f_1\right)} \cong \frac{p}{p+f_1}$$

2

$$(3) \qquad \frac{G(p)}{(D'/f_1)} \cong \left(\frac{p}{f_2}\right)^3$$

where q is the distance between the second focal plane of the first lens and the first focal plane of the second lens; p is the distance between the mask and a point defining the virtual image of the source; $f_1$ is the first focal length of the first lens; $f_1'$ is the first focal length of the second lens; $f_2$ is the second focal length of the first lens; $\delta_1$ and $\delta_1'$ are the changes in the first focal length of the first and the second lenses, respectively, due to a change in the energy of the ions in the beam; and $G(p) = ap^3 + bp^2 + cp + d$. The constants a, b, c and d are lens constants related to the transfer function from the first focal plane to the second focal plane of the first lens, in the presence of third order distortions, the transfer function being of the form:

$$\theta_2 = -r_1/f_2 + ar_1^3 + br_1^3 \theta_1 + cr_1 \theta_1^2 + d\theta_1^3 ,$$

where $r_1$, $\theta_1$ are the transverse radial and angular coordinates of a given ion path at the mask and $\theta_2$ is the transverse angular coordinate of the ion path at the second focal plane of the first lens. The coefficient D' is a coefficient in the transformation from the first focal plane to the second focal plane of the second lens:

$$r_2' \cong f_1\theta_2 + D' \theta_2^3$$

where $r_2'$ is the radial coordinate of the ray at the second focal plane of the second lens (i.e. the target position).

In preferred embodiments of the invention, the ions in the ion beam at the target are preferably at energy between about 50 and 200 kV. The ions in the ion beam at the mask are preferably at energy between about 1 and 10 kV. The image of the mask at the target is preferably reduced by at least a factor of 1.5 or more, the image at the target being no less than 10 mm in height and width.

Preferred embodiments of the invention also have the following features. A pair of field control apertures is provided, one disposed on each side of the second electrode of the Einzel lens to reduce the electric field strength arising from the second electrode in the area about the mask and the area about the aperture of the third electrode of the Einzel lens. Means are provided to apply a voltage ratio in the range of 7 - 20 or more between the electrodes of each of the first and second lenses. The means to provide the ion beam comprises an ion source and a lens located between the ion source and the mask for selecting the virtual source point along the axis of the optical column to fine-tune the system for simultaneously minimizing chromatic blurring and geometric aberration arising from the lenses. This lens is preferably a solenoid adapted to contribute to the selection of the desired ion species from various species of different mass issued from the source by differential deflection of the species according to their mass, preferably an aperture being located between the first and second lenses to prevent passage of ions differing in mass from the desired species.

According to another aspect of the invention, a multipole means is located within the second lens or beyond it for application preferably via a voltage control system of quadrupole fields to vary the magnification of the image at the target in the X direction relative to the magnification of the image in the Y direction, preferably the multipole means being located after the second lens in a region substantially free of electrical fields.

According to another aspect, a multipole means is located between the first and second lenses adapted to apply dipole fields for adjustable movement of the image in the plane perpendicular to the axis of the optical column, preferably the multipole means being further adapted to produce superposed higher order fields for fine control of distortion and blurring in the image. Preferably the multipole means is a pair of successive 16 pole curved arc arrays adapted to introduce a parallel offset to the beam. Also in preferred embodiments of the invention, a voltage adjustment device is provided for variation of the lens voltages for fine-tuning the balance of distortion and blurring in the image. Preferably the voltage adjustment device is further capable of disproportionate adjustment of the lens voltages for tuning the magnification of the image at the target.

Preferred embodiments of the first stated aspect of the invention also have the following features. The voltage on the first electrode of the gap lens is substantially the same as the voltage on the first and third electrodes of the Einzel lens and the voltage on the second electrode of the gap lens is substantially the same as the voltage on the second electrode of the Einzel lens such that ripple effects on the power supply do not substantially alter the voltage ratio of the lens column, thus substantially preserving the quality of the image at the target station.

The apparatus is constructed to enable the diameter of the gap lens to be changed to vary the magnification of the image at the target, the beam emerging from the second lens, upon the change, remaining substantially telecentric and substantially free of chromatic aberration and geometric distortion at the image plane. The lens column includes an external, rigid metal shell which extends substantially the full length of the lens column, with the shell being at constant potential and directly supporting the first and third electrode of the Einzel lens and the first electrode of the gap lens. The middle electrode of the Einzel lens is supported by insulators engaged for support upon the interior of the metal shell and the second electrode of the gap lens is supported via an insulator bushing supported by the downstream end of the rigid shell.

Preferably, a shield of high permeability magnetic material extends about said optical column. The shield may be supported by the rigid metal shell. Preferably the shield is comprised of a series of removable longitudinal segments that define a tubular shield and preferably end plates of high permeability magnetic material are mounted at each end of the tubular shield in a manner to provide magnetic continuity with the tubular shield.

In another aspect of the invention, an ion projection lithography apparatus comprises means to provide an ion beam, a mask in the path of the ion beam with apertures for producing a desired beam pattern, an optical column after the mask, the column defined by first and second principal lenses located along the ion path, the first lens being arranged to focus the ion beam, the second lens positioned after the first lens and being arranged to project a reduced image of the mask, a target station after the second lens for supporting a target that receives the image, and a shield of high permeability magnetic material extending about the optical column, the shield being comprised of a series of removable longitudinal segments that define a tubular shield and end plates of high permeability magnetic material in magnetic continuity with the tubular enclosure. Preferred embodiments of this aspect of the invention have the following features. Electrical conductors are provided inside the shield, arranged to provide adjustment to the magnetic field to which the ion beam is exposed, preferably the electrical conductors comprising an array of elongated loops within the shield. An array of longitudinally extending electrically conductive loops is associated with the shield, the loops being arranged to establish magnetic flux in the circumferential direction in the tubular shield, preferably there being provided means to apply an alternating electrical current to the loops to demagnetize the shield and means to apply a momentary small bias current to the loops to increase the magnetic permeability of the shield, preferably each of the conductive loops comprising longitudinally extending conductive segments extending along the interior and the exterior of the tubular shield and electrical conductors are provided inside the shield, arranged to provide adjustment to the magnetic field to which the ion beam is exposed.

In another aspect of the invention an ion projection lithography apparatus comprises means to provide an ion beam, a mask in the path of the ion beam with apertures for producing a desired beam pattern, an optical column after the mask, defined by first and second principal lenses located along the ion path with the first lens being arranged to focus the ion beam and the second lens positioned after the first lens and arranged to project a reduced image of the mask and a target station after the second lens for supporting a target that receives the image. The means to provide the ion beam comprises an ion source and a solenoid lens located between the ion source and the mask for selecting the virtual source point along the axis of the optical column, with the solenoid adapted to contribute to the selection of the desired ion specie from various species of different mass issued from the source by differential deflection of the species according to their mass. Preferably, the solenoid is a counterwound double solenoid adapted to prevent rotation of the ion beam during passage through the solenoid and preferably an aperture is located between the first and second lenses sized to prevent passage of ions differing in mass from the desired specie.

In yet another aspect of the present invention, an ion projection lithography apparatus comprises means to provide an ion beam, a mask in the path of the ion beam with apertures for producing a desired beam pattern, an optical column after the mask, defined by first and second principal lenses located along the ion path, with the first lens arranged to focus the ion beam, and the second lens positioned after the first lens and being arranged to project a reduced image of the mask, and a target station after the gap lens for supporting a target that receives the image. A multipole means is located within the second lens or beyond and a voltage control system is adapted to apply quadrupole fields to the multipole means to vary the magnification of the image at the target in the X direction relative to the magnification of the image in the Y direction. Preferably, the multipole means is located after the second lens in a region substantially free of electrical fields and preferably, is a sixteen pole circular array of arc-form electrodes.

The apparatus for projection ion beam lithography just described allows formation of low distortion, large field, reduced images of a mask pattern at a wafer plane. The stated configuration of ion optical elements enables simultaneous reduction of the effects of energy spread of the ion beam (chromatic blurring) and balance of image aberration caused by lens distortion in an optical column of practical size. In this connection, it can be noted that the two lenses form a real image of a mask at a wafer in a manner that greatly reduces degradation of the image arising from the aberrations intrinsic in the lenses themselves. As is known, in forming a real image of the mask with a single, electrostatic lens, barrel or pincushion distortion is suffered, depending on whether the image of the mask is formed before a crossover or after a crossover -- a crossover in this case being an image of the nearly point object generated by the ion source.

By providing the second lens following the first lens which in itself has the same type of defects, an image can be formed after the second lens in which distortion generated by the second lens corrects the distortion produced by the first lens. At a point, some distance down-stream from the second lens where an image that is substantially free of geometric distortion can be formed. Furthermore, a two lens combination can be selected so that at a specific point downstream of the second lens there is also a region less sensitive to the existence of energy spread in the ions, i.e. chromatic blurring. By coordinated selection of the parameters of the optical column, according to the invention, lens distortion and chromatic blurring are simultaneously minimized.

By use of the accelerating Einzel lens preceding the gap lens, the energy of the beam may be kept low while there can be sufficient ion energy at the ion source for its operation and the desired ion energy at the target can be at the level desired, there being no extreme voltages along the length of the column.

As mentioned above, in the preferred embodiment, the mask is positioned near the first focal plane of the first lens, which is an accelerating Einzel lens, and the wafer is positioned near the second focal plane of the second lens, which is a gap lens. The crossover of the beam resulting from the focusing of the first lens is located near the first focal plane of the second lens. Under these conditions, the ion paths from the mask image elements are substantially parallel to each other between the two lenses and the beam exiting the lens column and forming a real image of the mask at the wafer is substantially telecentric.

By positioning a solenoid directly after the ion source and before the mask as mentioned above, the solenoid is effective to both select the mass of ions impinging upon the wafer and to reduce the incident angle of the ion beam upon the mask, which therefore reduces the shadowing that can occur due to the mask thickness. The solenoid is also advantageously used to adjust the location of the virtual source point along the ion optical axis. This last function interplays with the balance of chromatic blurring from energy spread in the source and thereby permits fine tuning without. the need for mechanical shifting of the ion optical elements. Furthermore, selection of the virtual source point enables minimization of the machine's overall length (the distance between the source and wafer) for large field imaging at the wafer plane, for the important purposes of saving capital costs and logistical convenience.

## DESCRIPTION OF PREFERRED EMBODIMENTS

## BRIEF DESCRIPTION OF THE FIGURES

Figure 1 is a plan view of the ion beam lithography apparatus of the preferred embodiment;

Figure 1a is an elevation view of the apparatus of Figure 1;

Figure 1b is a diagrammatic side view of the magnetic shield of the apparatus of Fig. 1;

Figure 1c is a cross-sectional view taken on line 1c-1c in Fig. 1b.

Figure 2 is a three-dimensional cutaway view of the apparatus of Fig. 1 and 1a, indicating the ion beam trajectories and the inner components of the apparatus;

Figure 2a is an enlarged view of the column region shown in Figure 2;

Figure 2b is a block diagram schematic of the power supplies employed with the embodiment in Figure 1;

Figure 2c is a diagrammatic, perspective view of a multipole array employed in Fig. 1;

Figure 3 is a schematic two lens optical arrangement illustrating an ion beam ray being perturbed by the presence of lens distortions and/or chromatic blurring.

Figure 4 shows schematic views depicting the operation of the solenoid for mass selection and positioning the virtual source point;

Figure 5 is a view of the mask carousel and beam shutter from the embodiment in Fig. 1;

Figure 6 is a diagrammatic illustration of the correction of barrel and pin-cushion distortions achieved with a two lens system;

Figure 7 is a diagram showing the formation of a parallel ion path in the region between the lenses and the creation of a telecentric beam after the second lens according to the invention, and

Figure 8 is a graph illustrating lens distortion and line width broadening from chromatic blurring plotted as a function of the source-to-mask distance for two different distances between the lenses.

## Detailed Description

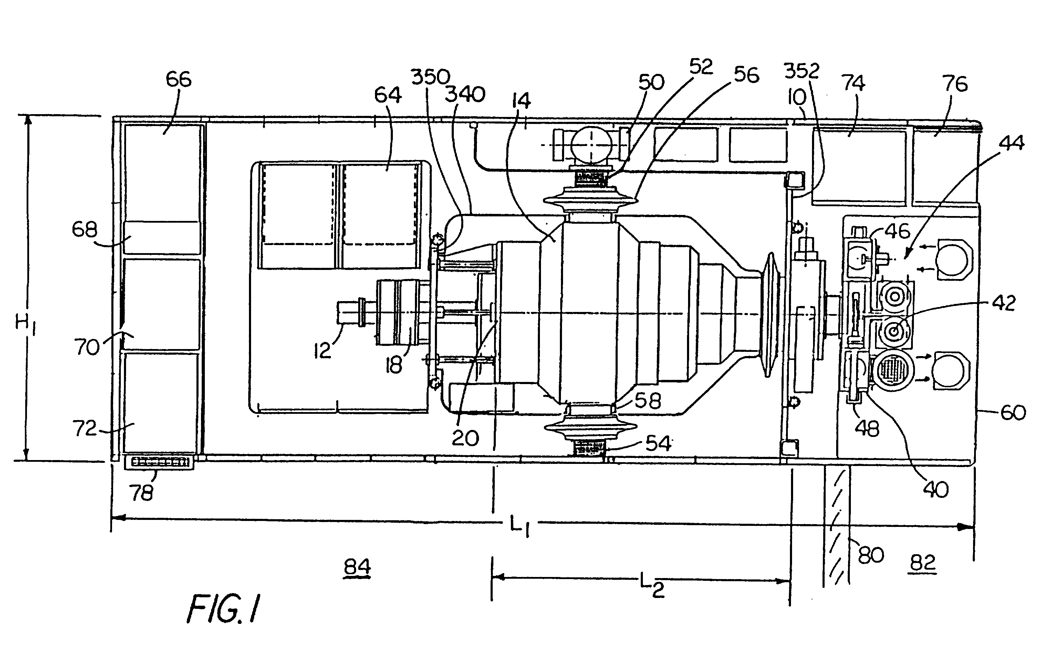

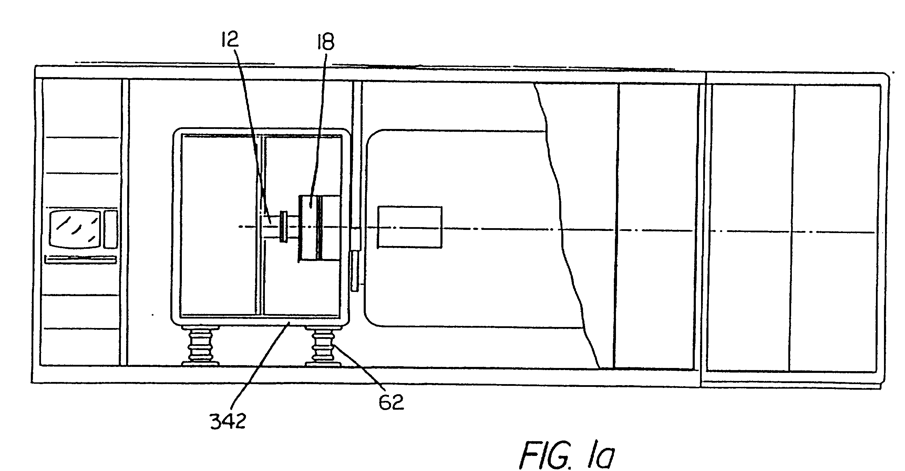

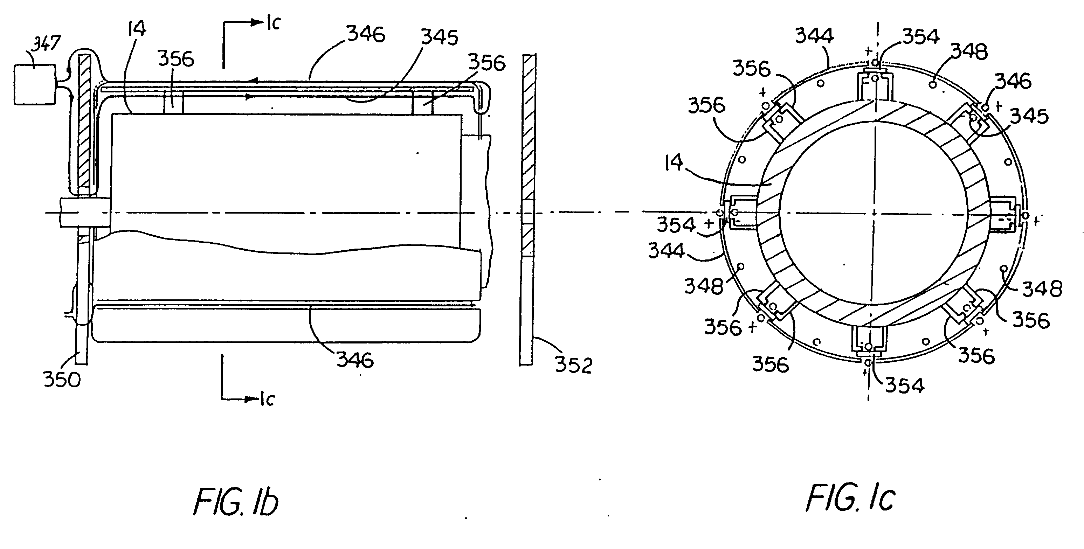

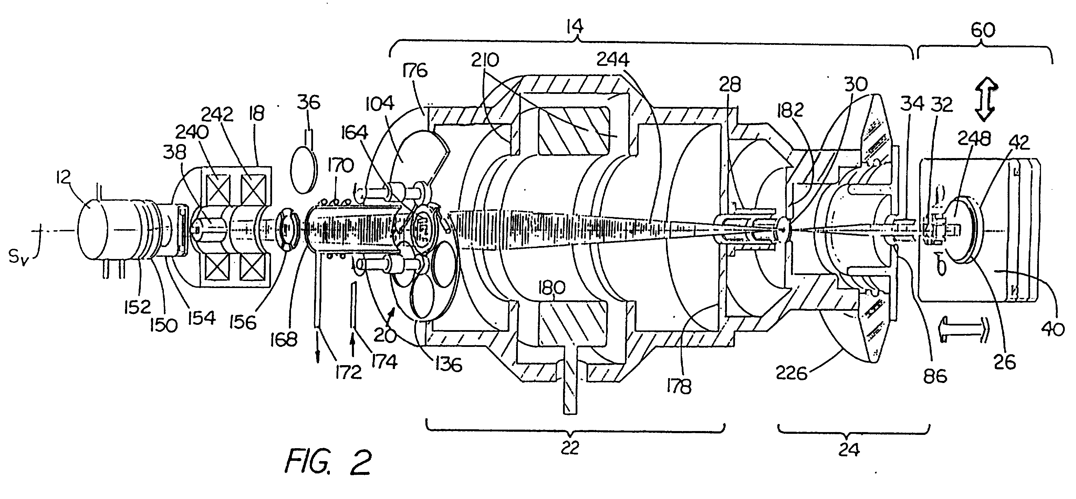

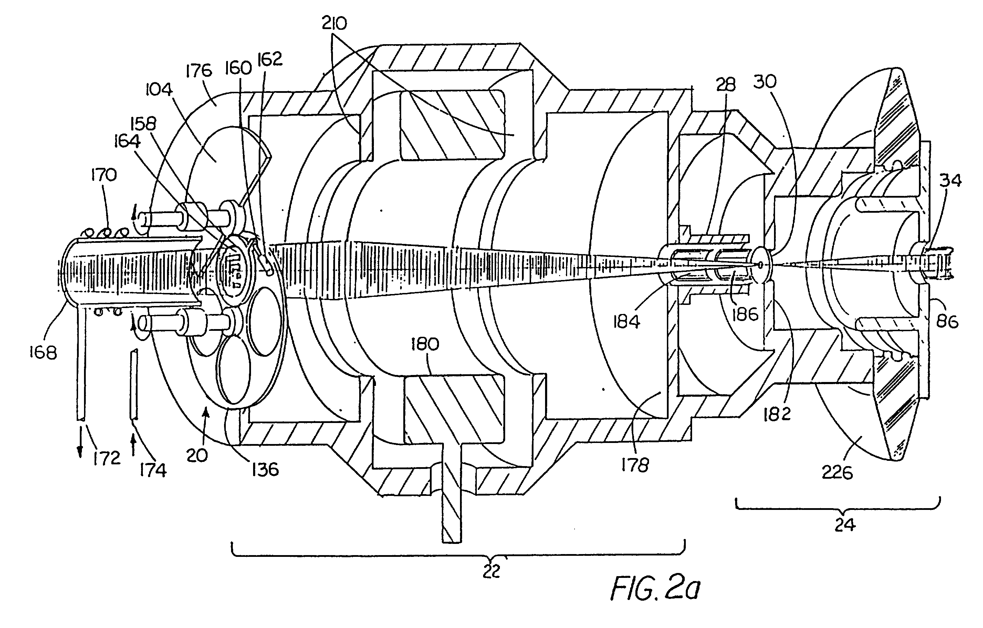

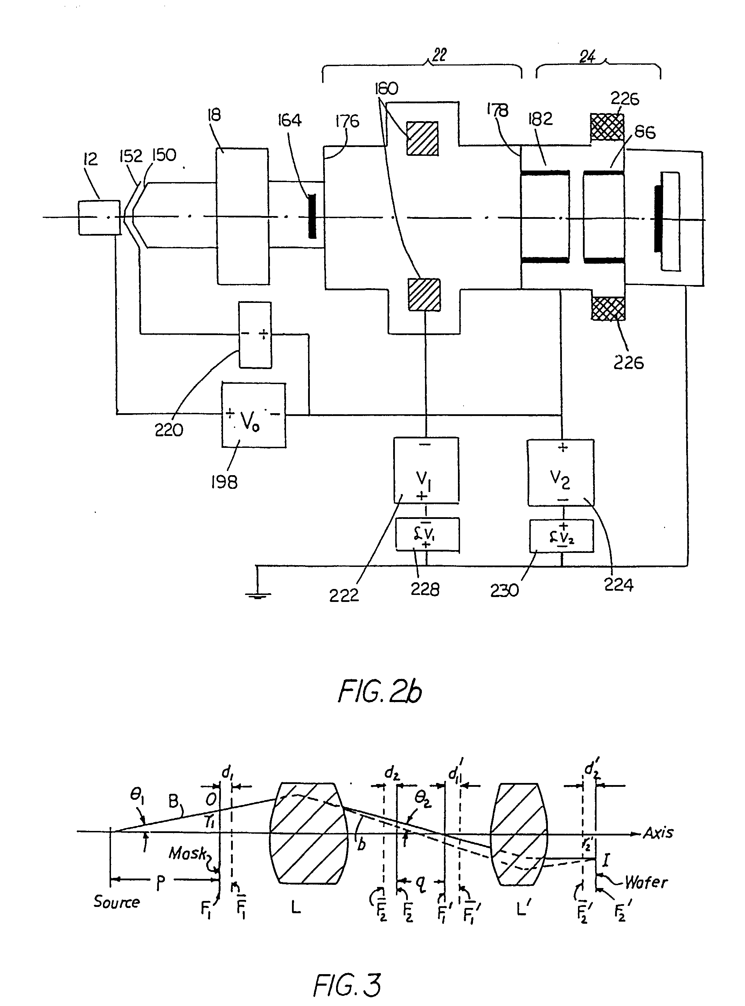

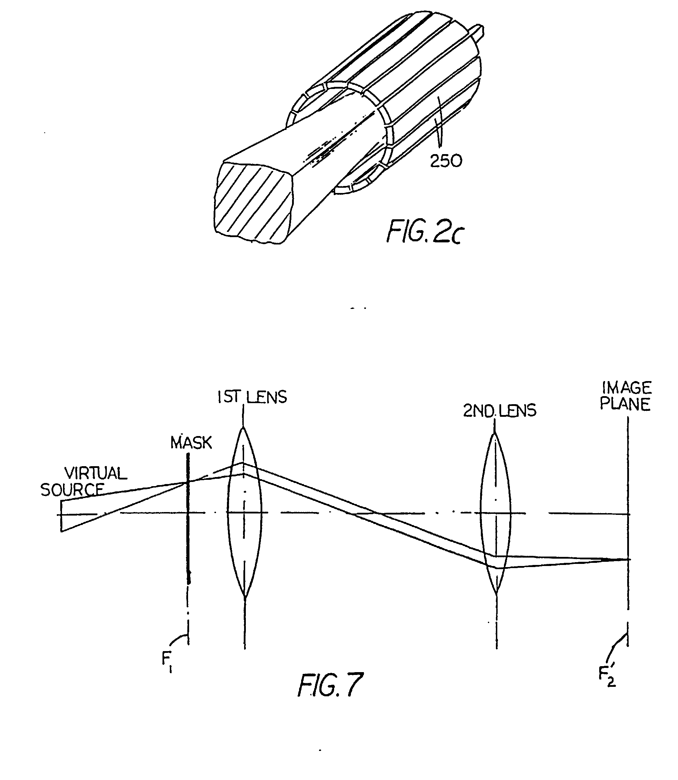

Referring to the plan view in Fig. 1 and the three dimensional cutaway view in Fig. 2 of the preferred embodiment, an enclosure 10 surrounds the ion beam lithography machine to provide protection and support for its components. These are, in sequence, the ion source 12, solenoid 18, mask assembly 20, the optical column 14 and the end station 60. A magnetic shield 340 made of high permeability iron alloy surrounds the entire column 14 to substantially eliminate external stray static and time varying magnetic fields such as those generated by the earth's magnetic field, building materials and electrical power sources. The magnetic continuity of the iron shield at each end of the column is provided by iron plates 350, 352.

Referring to Figs. 1b and 1c a cutaway side and cross sectional view of the shield, respectively are provided. The shield is constructed from a plurality of plates 344 which overlap and are supported by intermediate members 354 which in turn are supported by aluminum support members 356. An array of longitudinally extending wires 345 extend along the inside surface of the magnetic shield 340 and then return 346 over the outer surface to form an array of discrete elongated loops. By control device 347 these wire loops are excited with alternating electric current which reduces in magnitude with time, to demagnetize the shield. Thereafter, device 347 applies a momentary small dc current to increase the magnetic permeability of the shield. Additional longitudinally extending current carrying wires 348 which form another set of discrete elongated loops on the inside of the shield are provided to enable reduction of any stray magnetic field in the region of the ion beam. The current through the wires 348 and in the loops defined by wires 345, 346 are independently variable to obtain the minimum magnetic effect on the ion beam in the column.

Referring back now to Fig. 1 and 2, ions are produced from the ion source 12 and pass through a double coil solenoid 18 that serves to analyze the beam 244, to separate the required ion specie, in this embodiment helium, from other ion beam species issued from the ion source. Following the ion source body 12 there is a suppressor electrode 152 and an extractor electrode 150. The suppressor plate electrode has a higher negative potential with respect to the ion source plasma than the extractor electrode and thus prevents downstream electrons from being accelerated onto and thereby causing unwanted heating of the ion source body 12. The potentials and shapes of the suppressor and extraction electrodes are chosen to form an ion beam with a small effective size (less than 20 μm diameter). The potential of the extractor electrode 150 defines the energy of the beam passing towards the mask, independently of the potential selected for the suppressor electrode 152.

Following the extractor plate 150, an ion source (X,Y)-alignment stage 154 is provided which allows sliding movement of the entire source for proper alignment with respect to the axis of column 14. The two coils 240, 242 of the solenoid 18 are oppositely wound to provide counter directional magnetic excitation which acts upon the ions to prevent the beam from being rotated about its axis as a result of passage through the solenoid. The solenoid also reduces the angle at which the beam strikes the mask assembly 20; by thus reducing the solid angle of the ion beam, a greater flux may impinge upon the mask 164 and enter the column through its aperture. This reduction in angle is also important because the mask has a finite thickness (typically 1-5 μm) and the openings in it which define the pattern are typically very narrow. The reduction in the angle of incidence minimizes shadowing that occurs at the edges of the openings in the mask. Within the first coil 240 of the solenoid an electrical shutter 38 comprised of a multipole array is provided to deflect the beam from the column axis using dipole fields. This multipole may also apply quadrupole fields to adjust the magnification at the source beam in the X and Y directions (in the plane perpendicular to the beam axis) and thereby correct for elliptical distortions in the source.

Also provided in this region is a vacuum isolation valve 36 which allows the optical column 14 to be sealed from the source during source replacement or repair and a dose monitor 156 which is positioned beyond the solenoid. The outer periphery of the beam impinges upon a known area of the monitor 156 and the induced current is measured. In this way the flux of the beam through the column may be deduced and the exposure time required for a given resist determined.

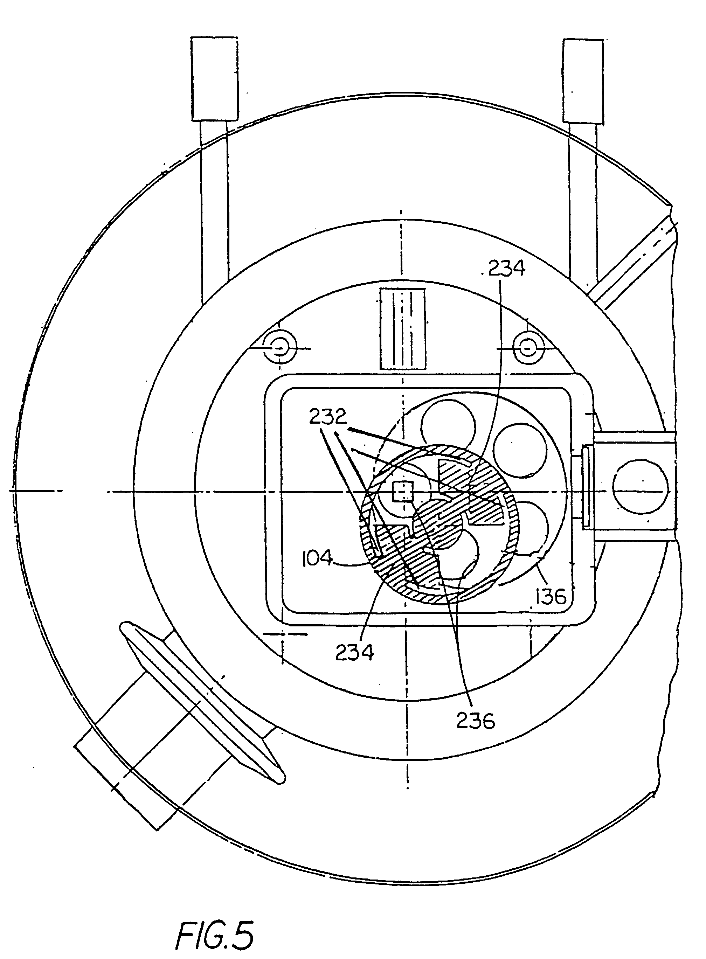

Following the dose monitor 156, the beam continues on to the mask assembly 20 which is shown in Fig. 2 and most clearly illustrated in a blown up view in Fig. 2a. The mask assembly 20 includes a complementary set of masks 164, one of which is shown, on a rotating disk 136. By "complementary set" a set of different masks is understood, each of which has openings that correspond to a respective part of a desired exposure pattern, such that successive exposure of the target through each of the mask exposes the target to the beam over the complete pattern. Each mask is mounted on a flexure mount 158 which permits rotation of the die pattern in response to linear motion of the pusher rod 160 driven by a piezo-electric transducer 162 (Fig. 2a). In the preferred embodiment, rotation of the mask 164 and hence rotation of the die pattern on the order of ± 500 microradians is controlled in response to a beam alignment system described below. Preceding the mask assembly 20 is a mechanical exposure shutter 104 (shown in more detail in Fig. 5) and a mask cooling cylinder 168 which serves to remove the heat generated by that part of the beam which does not pass through the openings in the mask but instead is intercepted by the mask. The cylinder radiatively cools the mask and extends about the beam axis. The cylinder itself is cooled by refrigerant introduced through inlet 174, circulated through concentric coils 170 and flowed out of the system through outlet 172. When the shutter 104 is positioned to block the beam from a mask, it simultaneously blocks the radiative cooling effects of the cylinder 168. The cooling system holds the mask at a near constant temperature thereby minimizing higher order geometric dimensional changes in the pattern on the mask.

Continuing to refer to Figs. 2 and 2a, the beam, with its angle slightly modified by the solenoid passes through the mask 164 and enters a large diameter accelerating Einzel lens 22. The Einzel lens, as is known, is a three electrode lens. In this embodiment, the first electrode 176 and third electrode 178 are integrally formed from the column envelope, a rigid metal shell, and are at equal potential. The second, or middle electrode 180 is at a different, ion accelerating potential. A pair of field control apertures 210 are formed on either side of the second electrode 180 to truncate its electrical field and thereby avoid distortion effects such fields are known to cause.

As is well known to those skilled in the art, the electrical fields arising from the lens electrodes may be shaped by the physical contour of the lens. In an ideal lens system, without apertures, the electrical field lines will be symmetric and predictable. In real lens systems, apertures in the lens electrodes are required to allow for passage of the ion beam and these apertures perturb the ideal shape of the field lines. In the three electrode Einzel lens, the field lines produced by the central electrode may pervade the apertures of the first and third electrodes. On the first electrode 176 side the field lines of the central electrode may also pervade the mask apertures at which point they take on a complex shape and exert forces on the ion beam and mask which result in perturbation errors at the image. On the side of the third electrode 178, the field lines are affected by the electrode aperture also generating unwanted perturbation errors at the image. The field control apertures 210 on either side of the second electrode 180 of the Einzel lens reduce the perturbations produced by the lens apertures. Shaping the field lines in this way therefore allows higher voltages to be applied to the electrodes.

The beam trajectory is changed by the Einzel lens so that it converges and forms a crossover or an image of the ion source between the Einzel lens 22 and a second, gap lens 24 which in turn is used to accelerate the ions and form an image of the mask on the target 26. As is well known, a gap lens is a two electrode lens having first and second electrodes at a potential difference. In this case the first electrode 182 of gap lens 24 is an integral portion of the rigid shell and the second electrode 86 is supported by insulator bushing 226 at the end of the rigid shell. As suggested by the beam trajectory, which is shown schematically, the gap lens 24 forms beams of ions travelling substantially parallel to the axis of the column, with cross-section forming an image of the mask as it strikes the wafer. A system of this type is termed to be telecentric. The substantially telecentric nature of the beam is advantageous because it reduces errors in the magnification of the image caused by irregularities in positioning the wafer along the optical axis or imperfections in the wafer itself such as warped surfaces.

Near the position where the Einzel lens 22 forms a crossover of the ion beam, there is multipole assembly 28, consisting of two successive multipoles 184, and 186 which, by application of suitable dipole fields alter the beam position in the X, Y plane (i.e., the target plane). By application of dipole fields equal in magnitude but opposite in sign to the two multipoles the beam may be offset from its original path, but remain parallel to it. The magnitude of these deflections is controlled by a beam alignment system to be described below and may be for example, +/- 5 microns. The multipoles are preferably an array of 16 curved arcs 250 as shown in Figure 2d which more closely approximate a cylindrical surface than conventional rods and may be used to generate any even powered fields (e.g. dipole, quadrupole, octupole etc.) up to a 16 pole field. In the practice of the preferred embodiment, the higher order fields are preset to correct for system distortions while the dipole fields for the deflection are superimposed.

As a practical feature in this preferred embodiment, locating the multipoles near the crossover allows the aperture of the multipole to be reduced since the beam diameter is converging toward its focus. Furthermore, the length to diameter ratio of a multipole should be approximately 5:1 and preferably 10:1 to avoid fringe field effects. With the diameter of multipole reduced because of its position near the crossover, the length can be reduced correspondingly such that it does not affect the overall system length in the design stage.

The multipole assembly 28 is closely followed by the mass selection aperture 30 which in conjunction with the solenoid serves to substantially select ions of only the desired mass for imaging onto the wafer. In a field free region, downstream from the aperture 30 and the gap lens 24, a multipole assembly 34 for generating quadrupole fields is provided for altering the relative magnification of the image in the X ($M_x$) and in the Y ($M_y$) direction in the wafer plane in opposition to each other. For example, if the magnification in the X-direction is made smaller, then the magnification in the Y-direction is larger. This element, therefore, is used to make fine adjustments to the magnification difference between X and Y to compensate for errors such as slight tilting of the wafer in the image plane about the X or Y axes. For absolute adjustment of the magnification the main lens voltages are used as described later herein. In the embodiment in Figure 2, the quadrupole assembly 34 is an array of sixteen curved arcs as shown in Figure 2d and is controlled by a beam alignment system to be described for making changes in the $M_x$ and $M_y$ by a factor of approximately +/-5 x $10^{-4}$. Furthermore, the sixteen curved arcs make it possible to arbitrarily select and therefore change the orientation of the X and Y axes. Furthermore, the location of the quadrupole assembly 34, away from the crossover is an important factor for minimizing the aberrations and distortions in the optical system. A quadrupole field at the crossover adds a first order term to a position where the balance of the two lenses comes into play. Therefore, the quadrupole is placed away from the crossover and preferably in a field free region. An alternative position for the quadrupole may be within the second electrode of the gap lens but still away from the crossover.

The accelerating Einzel/gap lens combination, Fig. 2, provides sufficient space between the gap lens 24 and the target 26 for location of a multipole of the required length. As previously mentioned in the discussion of the multipoles 28 positioned between the lenses, a certain diameter to length ratio must be maintained for optimum performance. After the gap lens, the beam diameter is larger (approximately 15 mm) than at the crossover (approximately 1 mm) and therefore a correspondingly larger multipole array must be employed for application of the quadrupole field. It should be evident to those skilled in the art, however, that the differential control of $M_x$ and $M_y$ using a quadrupole field in an ion projection lithography lens system, would find utility in other lens combinations besides the embodiment shown in Fig. 2.

Just before the beam strikes the wafer, there is an alignment beam scanner and detector system 32 which is used to monitor the position, magnification and orientation of the image formed on the wafer and produce signals to induce correcting action of the optical elements to the extent an error is detected.

An alignment system which may be used in the ion projection lithography apparatus according to the invention is disclosed in EP-A-294 363.

Referring back to Figs. 1 and 2, the wafer 248 is mounted on a stage 40 which allows precision X, Y (in the wafer plane) and Z (along the optical axis) motion so that the wafer can be stepped from one position to another, and replicas of the image pattern can be formed at different positions on the wafer. Furthermore, the position of the wafer along the optical axis can be adjusted. The wafer is secured by a chuck 42. When a wafer has been completely covered with repetitive patterns, that is, the wafer has been stepped through the selected sequence of exposures of the beam, its chuck 42 can then be removed from the back of the stage and taken out of the vacuum system through vacuum locks 46 and 48. The chuck with a new unexposed wafer is inserted in the position that is appropriate on the stage.

As shown in Fig. 1, various items of peripheral equipment are employed to operate the system. A suitable vacuum pump 50, illustrated as a turbo pump, evacuates the lens column. The pump is isolated from the lens both electrically and mechanically so that the lens assembly does not receive any vibration from external sources. A flexible bellows 52 is used to provide this isolation. The bellows has a vacuum on the inside and atmospheric pressure on the outside. The large sideways force that would exist on the lens is matched by an opposing bellows 54 on the other side of the machine. Since the lens column is at a high potential with respect to ground, an insulator bushing 56 for high voltage isolation is provided. An equivalent bushing 58 isolates the second bellows from ground on the other side of the machine. Other pumps on the lens and ion source assembly are treated in a similar manner, with the pumps located at ground potential

At ground potential in locations that are convenient for maintenance are various other power supplies and auxiliary functions for the machine as shown in Fig. 1. These include the lens power supplies 66, the power distribution panel 68 where the power is brought into the machine then distributed, a service module 70 which contains an isolation transformer to provide power to the components that are at high potential and controls for the vacuum system 72. The X, Y, Z stage electronic control systems are located near the stage in a cabinet 74. In console 76 there is a main touch screen control console containing the larger microprocessor or computer systems that are used to operate the machine. The functions of the control system can be transferred to an auxillary control system mounted at the rear of the machine 78 which can be used for maintenance. The machine may be bulk-head mounted, as indicated in Fig. 1, in such a way that the wafer handling part of the machine is in a clean room and the rest of the machine is in a via or maintenance room also maintained in clean conditions, but not as strictly clean as is required in an advanced semiconductor processing clean room. A wall is shown schematically as 80, the clean room 82, and the maintenance via, 84.

Around the ion source assembly is an enclosure 342 which is shown in an elevation view of this embodiment in Fig. 1a. The enclosure 342 is a cabinet in which pumps or power supplies or other controls can be placed and is isolated from ground potential by standing insulators 62. The ion source has a gas supply of the desired specie, e.g., hydrogen, helium or neon, that is in the enclosure of the ion source 64, shown in Fig. 1.

The overall length of the system, $L_1$ is 6.1 meters and the conjugate length (the distance from the mask to the target) is, $L_2$, 2.1 meters. The maximum height is, $H_1$, 2.5 meters. The ion beam expands from a point at the source 12 to approximately 10 mm at the first winding of the solenoid 240 and then to approximately 60 mm at the mask 164. The Einzel lens 22 focuses a beam of approximately 70 mm diameter to a crossover diameter of about 1 mm. After the crossover the beam at the gap lens 24 expands to between 15-24 mm (depending upon the size chosen for the gap lens) which diameter is substantially maintained on to the target 26 due to the telecentric nature of the beam.

In Figure 2b a block diagram of the power supplies employed in the embodiment in Figure 2 is shown. For positive ions, the source 12 is held at positive potential with respect to the extractor plate 150 by a first supply 198 at voltage $V_0$ which can vary the accelerating potential of extracted ions from, for example, 0-10 kV. A suppressor supply 220 holds the suppressor plate 152 at a negative potential with respect to the source for the purpose of repelling electrons.

A first system supply 222 applies a negative potential to the central electrode 180 of the Einzel lens 22 with respect to first 176 and third 178 electrodes. In this configuration of electrode potentials, the Einzel lens 22 is referred to as an accelerating Einzel lens, since the ions (positive ions in this embodiment) are accelerated between the first and second electrodes, then decelerated between the second and third electrodes. In this particular embodiment, the first and third electrodes being at the same potential, the net energy of the ions is not affected by this lens. The first 176 and third 178 electrode of the Einzel lens and the first electrode 182 of the gap lens are integral components of the rigid shell of the ion column 14 and receive a positive potential from a second power supply 224 as shown. (Other accelerating Einzel lens configurations are practical in which there is a voltage difference between the first and third electrodes so that energy reduction of the ions between the middle and third electrode is not equal to the energy gain between the first and middle electrode. Such configurations may be implemented here with the addition of the proper insulators and power supplier without departing from many aspects of the present invention.)

The potential across the gap lens is provided by connecting the negative terminal of the second power supply 224 to the second electrode 86 of the gap lens which is isolated from the column by insulator 226. The gap lens therefore accelerates the positive ions prior to their exit from the column. The first power supply 222 may set the voltage $V_1$

relative to ground of this second electrode on the Einzel lens between for example, 0-10 kV. The second supply 224 is variable over a typical range, $V_2$, of 50-200 kV with a typical value being near 100 kV. The power supplies 222 and 224 in practice are used to provide a typical lens voltage ratio for both lenses in the range of 7:1 to 20:1 depending on the injection ion energy $V_0$ set by power supply 198.

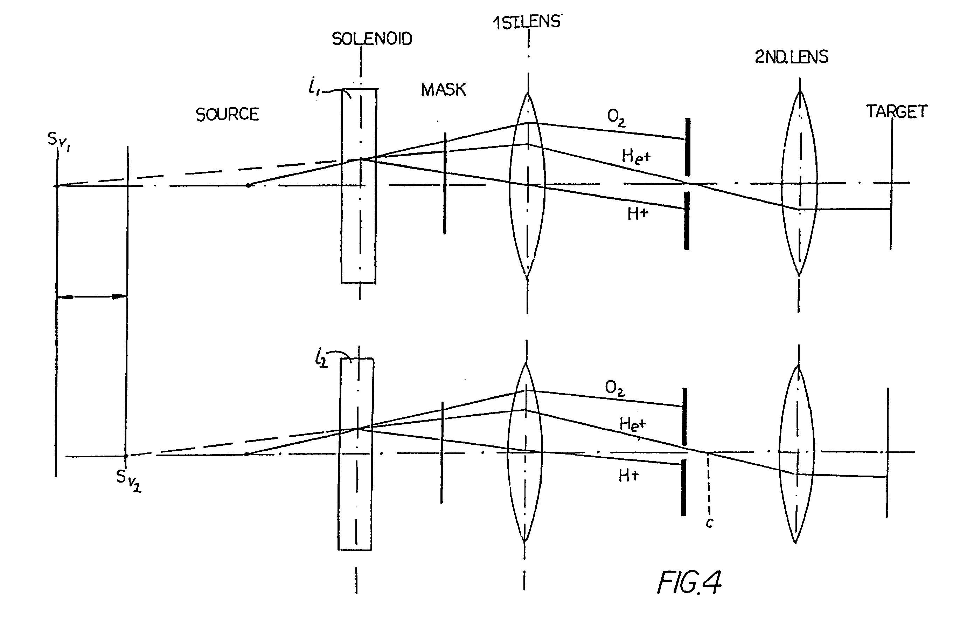

Supplemental supplies 228 and 230 provide small voltage adjustments $\delta V_1$, and $\delta V_2$ to system supplies 222 and 224, respectively. The configuration illustrated in Fig. 3 provides a voltage ratio on the Einzel lens of $V_E$ where:

$$V_E = \frac{V_0 + (V_1 + \delta V_1) + (V_2 + \delta V_2)}{V_0}$$

and a voltage ratio on the gap lens of $V_G$, where:

$$V_G = \frac{V_0 + (V_2 + \delta V_2)}{V_0}$$

In practice, the value of $V_1$ is kept small so that the voltage ratios applied across the electrodes of the Einzel lens and the gap lens are approximately equal to avoid the detrimental effects due to inherent ripple on the power supplies. The energy of the ions impinging upon the target is then in the range of approximately 50-200 kV.

The focal length of the electrostatic lenses vary as a function of the potential difference between their electrodes and therefore the magnification of an image at some position beyond the lens may be varied. In the preferred embodiment of Fig. 2, a two lens configuration, the magnification of the image at the target 26 is equal to the ratio of the first focal length of the second lens over the second focal length of the first lens. By selecting the voltage ratios of the first and second lenses the gross magnification may be selected. Furthermore, if the voltage ratios applied to the lenses are increased proportionately, the focal lengths decrease nearly in proportion but the magnification does not change. This adjustment may, however, affect the distortion of the two lenses as will be discussed below. Therefore, variation of the lens voltages provides a fine tuning means for distortion and magnification. For this fine tuning, the supplemental supplies 228 and 230 are preferably under computer control for variation of the lens voltages by a few percent (e.g. 0-300 volts). The supplemental supplies are preferably adjusted in response to signals generated by the alignment system for variation of the lens voltages by a few percent.

A practical advantage of the design, with the Einzel lens preceding the gap lens, is that the outer envelope of the column is at a single electrical potential, and therefore there is no need for an insulator between the lenses. This provides a very rigid mechanical structure which assures a stable column alignment. Mechanical rigidity also lowers the vibrations between the mask 20 and the wafer chuck 42 and makes it possible to align the ion source and mass filter to the column in a rigid way and to prevent ions from being displaced away from the axis.

An important further feature of this invention is the use of the solenoid in an ion lithography system for both mass selection and the variation of the virtual source point along the optical axis as illustrated in Fig. 4. The beam from the ion source passes through the solenoid which bends ions towards its axis so that the lighter mass ions such as hydrogen take a greater angle toward the axis and the wanted ions such as helium will move approximately parallel to the axis. Ions heavier than the desired ions such as oxygen will not be bent significantly and will continue substantially in diverging straight lines originating from the source. The first mass selection may occur in the plane of the mask. Heavier ions will lie off of the optical axis and will strike the mask assembly. Heavier ion species that do pass through the mask will still appear to be diverging from the ion source, and will not be significantly focused by the first lens. Near the crossover, the mass selection aperture, then, allows only a small fraction of those heavier ions that reach that position to pass through and arrive at the target. Light ions will tend to be concentrated on the axis and therefore may pass through the mask to the optical column. However, because of their proximity to the axis of the first lens, these ions will not be focused and therefore, will also strike the mass selection aperture.

The solenoid is also used to adjust the location of the virtual source on the axis of the machine. Adjusting this position varies the location of the crossover and interplays with the balance of chromatic aberrations arising from energy spread in the source which will be discussed further below. In the top panel of Fig. 4, the position of the virtual source of helium ions is $SV_1$ for a first current level $i_1$ applied to the solenoid. Under these conditions, the path of the helium ions is focused by the first lens to form a crossover at the position of a mass selection aperture. In the lower panel of Figure 4 a second current level $i_2$ is applied to the solenoid windings resulting in a slightly different ion path that produces a virtual source of helium ions at a $SV_2$. The helium ions in this case are focused to a crossover at a position slightly beyond the mass selection aperture. Since the condition for producing a telecentric beam after the second lens is to position the crossover near the first focal plane at the second lens, adjustment of the crossover position using the solenoid thereby allows the degree of telecentricity to be varied without the need to physically move the lenses along the optical axis. This is a significant advantage in terms of convenience and maintaining the optical alignment of the system.

As can be seen, at both positions of the virtual source in Fig. 4, the helium ions are selected for passage onto the target and both lighter and heavier ions are filtered. Therefore the solenoid may perform both functions simultaneously. It should be evident to those skilled in the art that the operation of the solenoid for mass selection and adjustment of the virtual source position would have utility in other electrostatic lens configurations which may include single lens systems or multilens systems of Einzel and gap lenses occurring in various sequences along the beam path. Furthermore, for use with the present lens column, the solenoid could be replaced by a simple electric lens if the mass selection function is performed differently. It should also be realized that the diameter of the aperture and its position along the optical axis may be selected for optimum mass filtering.

Referring back to Fig. 2, a double wound solenoid is employed in the preferred embodiment. The counter windings produce counter magnetic fields which prevent a net rotation of the beam. Furthermore, a focal length shorter by approximately 50% can be obtained over a single wound device since the beam experiences four sets of fringing fields as opposed to just two.

The carousel 136 and shutter assembly 104 is shown in a view along the optical axis from the source in Fig 5. The carousel in this embodiment holds four complementary masks that make up an entire pattern plus one metrology mask that is put in position in a metrology mode to measure machine distortion. The carousel rotates so that a mask comes into the axis of the column as shown in Figs. 2 and 5. When in position on the column a separate mechanism (not shown) clamps the mask to the back wall of the first lens. Opposite the position of the mask, is a vacuum lock chamber holding other masks and a mechanism that loads and unloads the masks from this carousel (not shown). Once a set of masks is unloaded then a vacuum valve is used to isolate that set from the main chamber and that set can be removed and replaced with another set. The carousel 136 is also compatible with the mask rotation assembly previously described which is capable of being rotated in a precise way to monitor the mask rotation as is required for the beam alignment system.

A rotating mechanical shutter 104 is used to control the exposure time. There are two shutter positions 234 which cover the mask and prevent exposure and two shutter positions 236 where the mask is fully exposed. Peripheral slots 232 in the shutter 104 are shown in Fig. 5. These allow the beam alignment function to occur without exposing the central die field of the mask. For example, just prior to exposure of the die field the shutter can be positioned such that three pairs of alignment marks in the mask are exposed to the beam through the slots. This is sufficient to determine five alignment parameters: X and Y translation in the wafer plane, rotation $\phi$ and magnification, $M_x$ and $M_y$, and the sixth beamlet being used to provide an error signal as a measure of the accuracy of the other beamlet signals. Once these parameters are established, exposure may begin. At some point during the exposure, during rotation of the shutter, one of the pairs is interchanged for another pair of alignment marks so that when the exposure is terminated the alignment has been retained right through exposure. The exposure shutter may likewise be used in coordination with an electrical shutter positioned, for example, between the source and the mask for the purpose of deflecting the beam from the mask between exposures.

When the shutter covers the mask, it will also prevent the mask from being exposed to the cold surface of the mask cooling scheme so the mask will remain at the ambient temperature of the surround, and the beam will hit the shutter which will cool in just the same way as the mask. Therefore no extra cooling is needed for the mechanical shutter.

Imperfections in the image produced in ion projection lithography systems arise from the energy spread of ions, referred to as chromatic blurring, and the inherent distortions caused by the lenses themselves, referred to as lens distortions. Because the spherical aberration coefficient in electrostatic lenses is always positive, this lens distortion cannot be eliminated by lens combinations as is done in light optics where the coefficient may be of either sign. Distortions in electrostatic lenses may be balanced, however, by adding a second lens following the first which in itself has the same type of defect. An image can then be formed after the second lens in which the distortion generated by the second lens balances the distortion produced by the first lens.

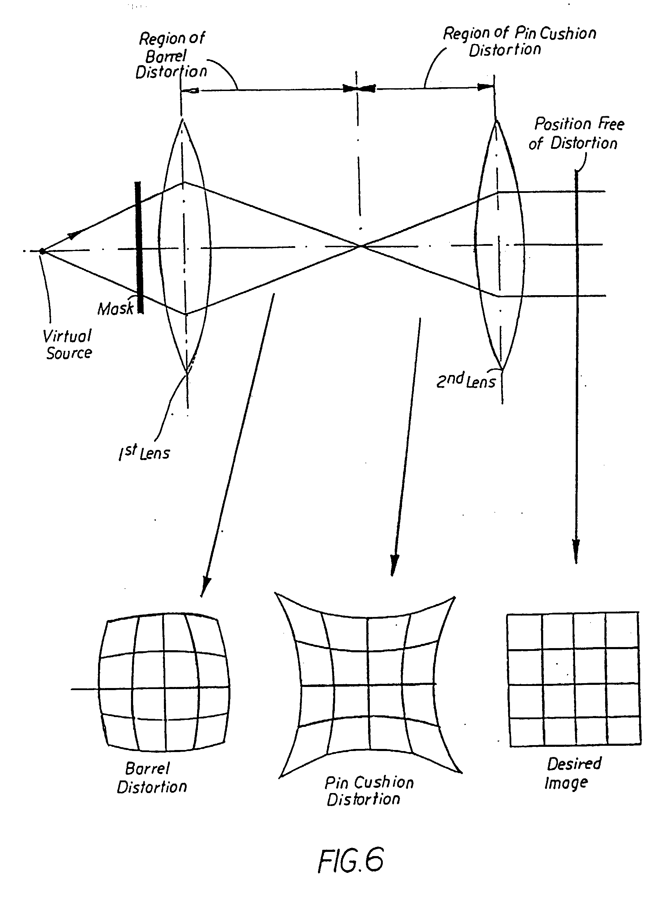

As is known, in forming a real image of a mask with a single, electrostatic lens, barrel or pincushion distortion is suffered, depending on whether the image of the mask is formed before a crossover or after a crossover as shown in Figure 6. If a second lens is added, barrel distortion it may introduce can be used to compensate for the pincushion distortion of the first lens. At some point downstream from the second lens, the barrel distortion of the first lens and pincushion distortion of the second lens are balanced and a distortion free image is formed. Further, the effect of chromatic blurring on the image in a two lens system is a function of various optical parameters which include the interlens distance and the source to mask distance. At the proper combination of these distances an image in which chromatic blurring are minimized occurs downstream from the second lens.

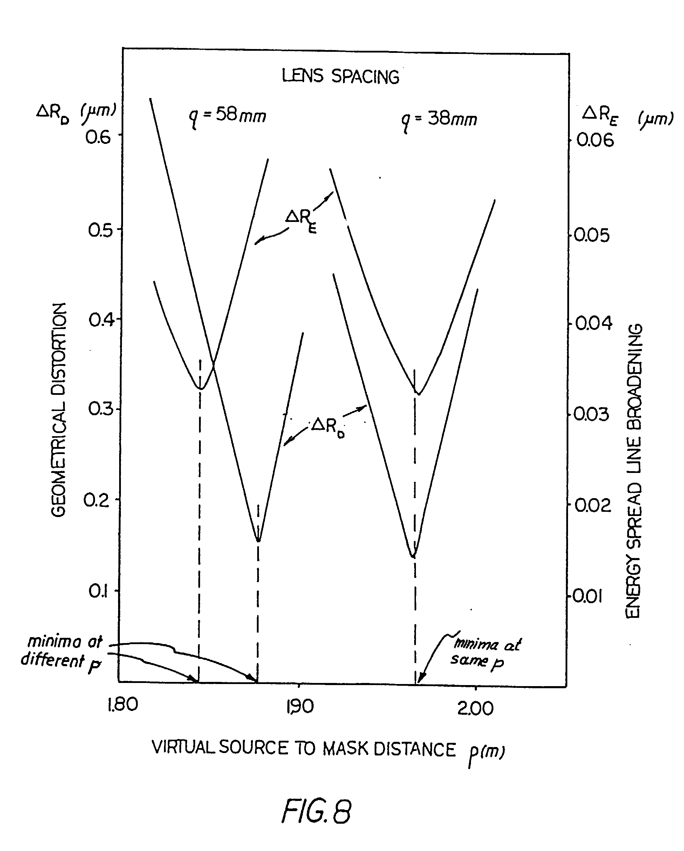

The two lens configuration of this invention allows the effects of chromatic blurring and the intrinsic distortions of the lenses to be minimized at the same image position in a system of practical size. Furthermore, a real image of the mask with distortions and blurring minimized is formed in a telecentric beam at the target. The first lens is configured to form a virtual image of a mask element at infinity, i.e. the beam paths between the two lenses from a specific mask element are substantially parallel to each other. The second lens forms a real image of that virtual image at its exit focal plane. To achieve these aforesaid conditions, the mask is placed near the first focal plane $F_1$ of the first lens and the wafer is near the second focal plane $F_2'$ of the second lens as indicated in Fig. 7. Therefore, with the mask and the image near the respective focal planes, the distance between the two lenses can be selected in the design stage to minimize chromatic blurring without affecting the magnification of the image. Since the distance between the two lenses may be selected, an additional parameter besides source-to-mask distance is provided, enabling coincident minima to be found for chromatic aberration and geometric or lens distortion.

For example, in Fig. 8, the lens distortion $\Delta R_D$ is plotted as a function of the virtual source to mask distance p for two different spacings q between the two lenses. As the source distance is changed the distortion passes through a minimum. If the chromatic blurring $\Delta R_E$ of the image is also plotted it is found to pass through a minimum at a particular source to mask distance for each lens spacing. Thus, there is a source distance for which a distortion minimum occurs and in general, another source distance for which a chromatic blurring minimum occurs. For an appropriately selected lens spacing it is possible to have the distortion and chromatic blurring minima occur at the same virtual source to mask distance.

Another feature of the optical system of this invention relates to generating different magnifications or reduction factors. The reduction factor is directly proportional to the focal length of the last lens, and the focal length of the last lens in turn is directly proportional to the lens diameter. By merely adjusting the diameter of the last lens, a corresponding change in the magnification may be obtained without affecting the balance of the distortions and aberrations which provides great flexibility. In the embodiment in Figure 2, for example, it is only necessary to adjust the diameter of the final electrode 86 in the gap lens to cover a range of different factors, for example, from 2:1-10:1. As a practical feature in the case of an Einzel/gap lens combination, removal of the gap lens final electrode 86 is made easy since it resides at the end of the column as shown in Fig. 2. In another embodiment, the first electrode of the gap lens is made detachable from the lens column to allow the diameter of both electrodes to be changed.

Lens Distortion, Chromatic Blurring and Telecentricity Relationships

For purposes of mathematical treatment, Fig. 3 shows an ion optical system featuring the two principal lenses L and L' with focal planes $F_1$, $F_2$ and $F_1'$, $F_2'$ respectively. The mask is located at the focal plane, $F_1$ and the wafer at the final image plane $F_2'$. A nominally point source is located at a distance in front of F, and is imaged by L at $F_1'$. This source may be virtual or real.

A distance p is defined between the source and the mask and a drift distance q between the second focal plane $F_2$ of the first lens and the first focal plane $F_1'$ of the second lens. The solid ray B depicts the ideal first order path of a ray from ion source to image and the broken ray b depicts the path of a ray path perturbed by lens distortion and/or chromatic aberrations. In the case of such imperfections the focal planes are known to shift position and are represented in Figure 3 by broken vertical lines $\bar{F}_1$, and $\bar{F}_2$ being the shifted first and second focal planes of the first lens, respectively, with the distances $d_1 = F_1 - \bar{F}_1$ and $d_2 = \bar{F}_2 - F_2$ and $\bar{F}_1'$ and $\bar{F}_2'$ being the shifted first and second focal planes of the second lens, respectively with $d_1' = F_1' - \bar{F}_1'$ $d_2' = \bar{F}_2' - F_2'$.

In first order optics the transverse coordinates of a particular ray (r, θ) transform linearly into new coordinates (r', θ') at another position along the axis of the system. This is conveniently represented as a matrix, transform:

$$\begin{bmatrix} r' \\ \theta' \end{bmatrix} = A \begin{bmatrix} r \\ \theta \end{bmatrix} = \begin{bmatrix} A_{11} & A_{12} \\ A_{21} & A_{22} \end{bmatrix} \begin{bmatrix} r \\ \theta \end{bmatrix} \tag{1}$$

where A is the transform matrix.

For focal plane to focal plane transfer through the lens L the transform matrix T has the form:

$$T = \begin{bmatrix} 0 & f_1 \\ -\dfrac{1}{f_2} & 0 \end{bmatrix} \tag{2}$$

where $f_1$ and $f_2$ are the first and second focal lengths of lens L, while for lens L' the transform matrix T' is

$$T' \;=\; \begin{bmatrix} 0 & f_1' \\ -\dfrac{1}{f_2} & 0 \end{bmatrix} \tag{3}$$

where $f_1'$ and $f_2'$ are the first and second focal lengths of lens L' and for the drift q from $F_2$ to $F_1'$ the transform matrix Q is:

$$Q \;=\; \begin{bmatrix} 1 & q \\ 0 & 1 \end{bmatrix} \tag{4}$$

The entire transform mask to wafer $\Gamma$ is thus:

$$\Gamma \;=\; T'QT \;=\; \begin{bmatrix} -\dfrac{f_1}{f_2} & 0 \\ \dfrac{q}{f_2 f_2} & -\dfrac{f_1}{f_2} \end{bmatrix} \tag{5}$$

where eq. 5 follows from straight forward matrix multiplication. The specific transformation equations are thus:

$$
\begin{aligned}
r_2' &= \left(\frac{f_1}{f_2}\right)\cdot r_1 \\
\theta_2' &= \frac{1}{f_2 f_2}\left[q\cdot r_1 \quad - \quad f_1 f_2 \;\; \theta_1\right] = \\
&= \frac{1}{f_2 f_2}\,(qp \quad - \quad f_1 f_2)\;\theta_1
\end{aligned}
\tag{6}
$$

where use has been made of the fact that

$$r_1 = p\cdot\theta_1 \tag{7}$$

for a nominally point source.

Because the (1,2) element of the matrix $\Gamma$ is zero, the final position along the axis corresponds to a Gaussian image; i.e. $r_2'$ is independent of $\theta_1$.

Furthermore, from eq. (6) the magnification is

$$M \;=\; -\left(\frac{f_1}{f_2}\right) \tag{8}$$

representing a real inverted image because of the negative sign. Also from eq. (6), the telecentric condition ($\theta_2'$ = 0) requires

$$qp = f_1\, f_2 \tag{9}$$

It should be noted that the image condition and the value of the magnification M are independent of q and p, whereas the telecentric condition defines a relation between these two distances.

The simple linear transformation described above is perturbed by both chromatic effects (energy spread in the ion beam) and lens distortions intrinsic in the lenses L and L'. If the perturbations on T and T' are $\Delta$ and $\Delta'$ respectively, the perturbed transform is

$$\Gamma' = \Gamma + P = (T' + \Delta')\, Q\, (T+\Delta) = T'QT + \Delta'Q\Delta + T'Q\Delta + \Delta'QT \tag{10}$$

Retaining only first order perturbation terms leads to the following expression for the perturbation matrix P:

$$P = \Gamma' - \Gamma = T'Q\Delta + \Delta'QT \tag{11}$$

The conditions for which the final beam transverse position $r_2'$ remains unperturbed will now be examined. According to eq. (11):

$$\Delta r'_2 = P_{11} r_1 + P_{12} \theta_1 = (p P_{11} + P_{12})\, \theta_1 \tag{12}$$

Where $P_{11}$ is the (1,1) element of the matrix P and $P_{12}$ is the (1,2) element. Thus $\Delta r_2' = 0$ and the beam remains unperturbed for all $\theta_1$ provided:

$$p P_{11} + P_{12} = 0 \tag{13}$$

For chromatic blurring, when the ion energy changes an amount $\delta E$ from a nominal value E the focal lengths change from $f_i$ to $\bar{f}_i$ (i = 1,2) where

$$f_i = f_i - \delta_i \; ; \; f'_i = f'_i - \delta'_i \tag{14}$$

and

$$\delta_i \;=\; -\; \left(\frac{\delta f_i}{\delta E}\right) \; \delta E \qquad ; \qquad \delta'_i \;=\; -\; \left(\frac{\delta f'_i}{\delta E}\right) \; \delta E \tag{15}$$

In addition the focal planes change their location from $F_i$ to $\bar{F}_i$ and $\bar{F}_i'$ to $\bar{F}_i'$ respectively corresponding to displacements along the beam axis as shown in Fig. 3 and therefore:.

$$d_i = \overline{F_i \bar{F}_i} \qquad ; \qquad d'_i = \overline{F'_i \bar{F'}_1} \tag{16}$$

The well known Liouville's theorem applies independently of these changes. To zeroth order of approximation sufficient for the discussion which follows:

$$\bar{f}_1/\bar{f}_2 = f_1/f_2 \; ; \; \bar{f'}_1/\bar{f'}_2 = f'_1/f'_2 \tag{17}$$

and consequently:

$$\delta_2 f_1 = \delta_1 f_2 \; ; \; \delta'_2 f'_1 = \delta'_1 f'_2 \tag{18}$$

For lens L the transformation from $F_1$ to $F_2$ becomes

$$T + \Delta = \begin{bmatrix} 1 & d_2 \\ 0 & 1 \end{bmatrix} \begin{bmatrix} 0 & f_1 - \delta_1 \\ -1/(f_2 - \delta_2) & 0 \end{bmatrix} \begin{bmatrix} 1 & d_1 \\ 0 & 1 \end{bmatrix} \tag{19}$$

from which one can derive, retaining only first order terms in d and $\delta$:

$$\Delta = -\frac{1}{f_2} \begin{bmatrix} d_2 & \delta_1 f_2 \\ \delta_2/f_2 & d_1 \end{bmatrix} \tag{20}$$

Similarly for lens L'

$$\Delta' = -\frac{1}{f'_2} \begin{bmatrix} d'_2 & \delta'_1 f'_2 \\ \delta'_2/f'_2 & d'_1 \end{bmatrix} \tag{21}$$

Substituting these expressions for $\Delta$ and $\Delta'$ into eq. (11) and using the explicitly derived expression for $P_{11}$ and $P_{12}$ in eq. (13) gives:

$$\frac{\delta_2 f_1}{d'_2 f_2} = \frac{(qp - f_1 f_2) + pf'_1\left(\delta'_2/d'_2\right)}{f_1 f'_2 \quad (d_1 f_2/\delta_2 f_1 + p/f_1)} \tag{22}$$

In general then, it is possible to select q and p such that eqs. (9) and (22) are simultaneously satisfied implying that chromatic blurring is absent at the image plane and the final beam is telecentric. Without changing the nature of this general result it is possible to simplify eq. (22). For both Einzel lenses and gap lenses operating at a voltage ratio of 10:1 or greater, energy change in the incident ions do not result in a significant change in the location of the principal planes. In other words, the shift in focal planes is mainly a result of the change in focal length, i.e.:

$$d_i \cong \delta_i ; \qquad d''_i \cong \delta'_i \tag{23}$$

With this approximation and the approximation of equation (18) the results in summary are: For the telecentricity condition:

$$qp = f_1 f_2 \tag{24}$$

For the achromatic condition with telecentricity:

$$\frac{(\delta_1/f_1)}{\left(\delta'_1/f'_1\right)} \cong \frac{p}{(p + f_1)} \tag{25}$$

In practice a solution can be found for p provided $\delta_1/f_1 < \delta_1'/f_1'$, i.e. the first lens must have a smaller chromatic effect than the second. Note that the choice of p and q to satisfy eqs. (24) and (25) does not in any way affect the image or magnification condition discussed above. Furthermore, the last lens can be simply scaled in size without affecting the conditions expressed by eqs. (24) and (25). This is because $\delta_1'$ is proportional to $f_1'$ regardless of the lens size. Scaling only the size of the last lens provides a convenient way to change the magnification for the column.

The effects of lens distortion will now be considered. When an ion passes through a round lens, third order aberrations occur. The focal plane to focal plane transfer including these aberrations has the form:

$$r_2 = f_1\theta_1 + Ar_1^3 + Br_1^2\theta_1 + Cr_1\theta_1^2 + D\theta_1^3 \tag{26}$$

$$\theta_2 = -r_1/f_2 + ar_1^3 + br_1^2\theta_1 + cr_1\theta_1^2 + d\theta_1^3$$

Where A, B, C, D and a, b, c, d, are constants for a particular lens geometry and voltage ratio. Applying these expressions to lens L, along with the point source condition $r_1 = p\theta_1$ of eq. (7), leads to the following result for the pertubation matrix $\Delta$:

$$\Delta = \begin{bmatrix} 0 & F(p)\theta_1^2 \\ 0 & G(p)\theta_1^2 \end{bmatrix} \tag{27}$$

where:

$$F(p) = Ap^3 + Bp^2 + Cp + D \tag{28}$$

$$G(p) = ap^3 + bp^2 + cp + d$$

The coordinates of a ray at $F_1'$ of lens L' are given by

$$\begin{bmatrix} r_1' \\ \theta_1' \end{bmatrix} = \begin{bmatrix} 1 & q \\ 0 & 1 \end{bmatrix} \begin{bmatrix} r_2 \\ \theta_2 \end{bmatrix} \tag{29}$$

Ignoring induced aberrations greater than third order eqs. (7), (26) and (29) lead to

$$r_1' \cong (f_1 - qp/f_2)\,\theta_1 \tag{30}$$

$$\theta_1' \cong -(p/f_2)\,\theta_1$$

Assuming the telecentricity condition is nearly satisfied, $r_1'$ is small and powers greater than $r_1'^2$ will be disregarded. Applying eq. (26) to lens L' gives

$$r_2' \cong f_1\theta_1' + C\,(qp/f_2 - f_1)\,(p/f_2)\theta_1^2\theta_1' + D(p/f_2)^2\theta_1^2\theta_1' \tag{31}$$

$$\theta_2' \cong -r_1'/f_2 + c\,(qp/f_2 - f_1)(p/f_2)\theta_1^2\theta_1' + d(p/f_2)^2\theta_1^2\theta_1'$$

The perturbation transformation matrix for L' immediately follows:

$$\Delta' = \begin{bmatrix} 0 & F'(p)\theta_1^2 \\ 0 & G'(p)\theta_1^2 \end{bmatrix} \qquad (32)$$

where

$$F'(p) = C' \, (qp/f_2 - f_1) \, (p/f_2) + D'(p/f_2)^2 \qquad (33)$$

$$G'(p) = c' \, (qp/f_2 - f_1) \, (p/f_2) + d'(p/f_2)^2$$

Substituting $\Delta$ and $\Delta'$ above, into eq. (11) gives the total perturbation transform matrix P:

$$P = \begin{bmatrix} -\dfrac{F'(p)}{f_2}\theta_1^2 & f'_1 G(p)\theta_1^2 \\ -\dfrac{G'(p)}{f_2}\theta'_1 & -1/f'_2\{F(p) + qG(p)\}\theta_1^2 \end{bmatrix} \qquad (34)$$

Thus the perturbation $\Delta r_2'$ at the image plane resulting from geometrical aberrations is:

$$\Delta r'_2 = - [f'_1 G(p) - (p/f_2)F'(p)]\theta_1^3 \qquad (35)$$

The condition for a distortion free image is thus:

$$(f_2/p) \, G(p) = F'(p)/f'_1 \qquad (36)$$

and for a nearly telecentric situation, eq (33) implies:

$$F'(p) \cong D'(p/f_2)^2 \qquad (37)$$

which gives the distortion free condition with telecentricity:

$$G(p)/(D'/f'_1) \cong (p/f_2)^3 \qquad (38)$$

According to eq. (31) D' has the dimensions of length. Hence, as the last lens is scaled in size, $D'/f_1'$ will remain constant and eq. (38) once satisfied is always satisfied regardless of the actual size of the last lens. As mentioned above this is also the situation for the achromatic condition.

Since $G(p)$ is a polynomial in p, a real solution of eq. (38) for p is not a priori assured. However, the choice of lenses and their relative parameters, voltage ratio and size, can be selected to enable acceptable practical values to be found for p and q that simultaneously satisfy the three conditions expressed by eg (24), (25) and (38) and thus assures the effects of lens distortion and chromatic blurring to be minimized in a telecentric beam.

In accordance with these principles, the lens system of the invention, in which the first lens is an accelerating Einzel lens and the second is a gap lens, enables substantial, simultaneous minimization of chromatic blurring and lens distortion and the obtaining of near telecentricity, together with the other important attributes of the lens system that have been described. It is a particular feature that the ion beam of such a system may have a desired, low level of energy at the mask and a much higher energy at the wafer. The accelerating Einzel lens is only slightly more aberrant than the gap lens which it precedes in the design of Fig. 2. In order to satisfy achromaticity $\delta_1/f_1 < \delta_1'/f_1'$ the gap lens

may be chosen to operate at a lower voltage ratio than the accelerating Einzel lens. In general, however, $G(p) > D'/f_1'$ and eq (38) is rather easy to satisfy with reasonably large values of p for this configuration.

The condition of perfect telecentricity is not a fundamental lithographic requirement. Accepting a condition where the beam is near telecentric rather than perfectly telecentric allows more scope and flexibility in simultaneously meeting the requirements for achromatic, distortion free transport.

Employing the ion optical scheme described in the preferred embodiment shown in Fig. 2, the system is capable of simultaneously providing the following performance characteristics for the production of quality microchips with submicron features.

1. The formation of an image that is reduced by at least a factor of 1.5:1 or 2:1 compared to the mask and is at least 10 mm squared at the image plane.

2. The image distortions are less than 0.2 microns.

3. The blurring of images due to energy spread of the ions is less than 50 nm.

4. The system is nearly telecentric at the image plane.

5. The initial energy of the ions (at the mask plane) is 1-10 KeV.

6. The final energy of the ions hitting the target is 50-200 KeV.

7. The machine dimensions are consistent with the requirements of typical integrated circuit manufacturing facility due to the shortness of the conjugate length of the lens system.

Several modifications and variations of the present invention are possible when considered in the light of the above teachings. It is therefore understood that the scope of the present invention is not to be limited to the details disclosed herein, but may be practiced other than as specially described, and is intended only to be limited by the claims appended hereto:

## Claims

1. An ion projection lithography apparatus comprising:

means to provide an ion beam,

a mask in the path of said ion beam with apertures for producing a desired beam pattern,

an optical column after said mask,

said column being defined by first and second principal lenses located along said ion path,

said first lens being arranged to focus said ion beam and being an accelerating Einzel lens arranged to form a crossover within said column,

said second lens being positioned after the crossover of said first lens and being a gap lens, arranged to project a reduced image of said mask, and

a target station after said second lens for supporting a target that receives said image.

2. The apparatus of claim 1 wherein said mask is located substantially at the first focal plane of said first lens and said target station is located substantially at the second focal plane of said second lens.

3. The apparatus of claim 2 wherein said means to provide said ion beam comprises an ion source and means to provide to said optical column a virtual image of said ion source more distant from said column than said ion source and the distances (1) between the second focal plane of said first lens and the first focal plane of said second lens, and (2) between said mask and a point defining the virtual image of said source and said mask, being selected to produce said image of said mask at said target with chromatic blurring and geometric distortion arising from said lenses simultaneously substantially minimized.

4. The apparatus of claim 3 in which said lenses are positioned to locate said crossover of said first lens substantially at the first focal plane of said second lens to produce a substantially telecentric beam following said second lens.

5. The ion projection lithography system of claim 1 wherein said lens system simultaneously satisfies substantially the following conditions whereby the beam emerging from the second lens is substantially telecentric and when it reaches the image plane is substantially free of chromatic blurring and geometric distortion;

$$(1) \qquad qp = f_1\,f_2$$

$$(2) \qquad \frac{(\delta_1/f_1)}{(\delta'_1/f'_1)} \cong \frac{p}{p+f_1}$$

$$(3) \qquad \frac{G(p)}{(D'/f_1)} \cong \left(\frac{p}{f_2}\right)^3$$

where q is the distance between the second focal plane of the first lens and the first focal plane of the second lens,

p is the distance between a point defining the virtual image of said source and said mask,

$f_1$ is the first focal length of said first lens,

$f_1'$ is the first focal length of said second lens,

$f_2$ is the second focal length of said first lens,

$\delta_1$ and $\delta_1'$ are the changes in the first focal length of said first and said second lenses, respectively, due to a change in the energy of said ions in said beam,

$$G(p) = ap^3 + bp^2 + cp + d$$

where a, b, c and d are lens constants related to the transfer function from the first focal plane to the second focal plane of the first lens, in the presence of third order aberrations, said transfer function being of the form:

$$\theta_2 = -r_1/f_2 + ar^3_1 + br^2_1\theta_1 + cr_1\theta^2_1 + d\theta^3_1$$

where $\theta_2$ is the transformed transverse angular coordinate of a given ion ray at the second focal plane of said first lens, $r_1$, $\theta_1$, are said transverse coordinates at the first focal plane of said first lens at said mask and D' is a coefficient in the transformation from the first focal plane to the second focal plane of the second lens;

$$r_2' = f_1' \, \theta_2 + D'\theta_2^3$$

where $r_2$ is the radial coordinate of the ray at the second focal plane of the second lens.

6. The apparatus of any of the claims 1 - 5 adapted to provide ions in said ion beam at said target at energy between about 50 and 200 kV.

7. The apparatus of claim 6 adapted to provide ions in said ion beam at the mask at energy between about 1 and 10 kV.

8. The apparatus of any of the claims 1 - 5 wherein said image of said mask at said target is reduced by a factor of 1,5 or more, said image at said target being no less than 10 mm in width and height.

9. The apparatus of any of claims 1 - 5 further comprising a pair of field control apertures, one disposed on each side of the second electrode of said Einzel lens for reducing the electric field strength arising from said second electrode in the area about said mask and the area about the aperture of the third electrode of said Einzel lens.

10. The apparatus of any one of claims 1 - 5 adapted to apply a voltage ratio in the range of 7 - 20 to said first and second lenses.

11. The apparatus of any of claims 1 - 5 wherein said means to provide said ion beam comprises an ion source and a lens located between said ion source and said mask for selecting the virtual source point along the axis of said optical column to fine-tune said system for simultaneously minimizing chromatic blurring and lens distortion.

12. The apparatus of claim 11 wherein said lens is a solenoid, said solenoid adapted to contribute to the selection of the desired ion species from various species of different mass issued from said source by differential deflection of said species according to their mass.

13. The apparatus of claim 12 further comprising an aperture located between said first and second lenses to prevent passage of ions differing in mass from the desired species.

14. The apparatus of any one of claims 1 - 5 further comprising a multipole means located within said second lens or beyond it for application preferably via a voltage control system of quadrupole fields to vary the magnification of the image at said target in the X direction relative to the magnification of the image in the Y direction.

15. The apparatus of claim 14 wherein said multipole means is located after said second lens in a region substantially free of electrical fields.

16. The apparatus of any of claims 1 - 5 further comprising a multipole means located between said first and second lenses adapted to apply dipole fields for adjustable movement of said image in the plane perpendicular to the axis of said optical column.

17. The apparatus of claim 16 wherein said multipole means is further adapted to produce superposed higher order fields for control of distortion and blurring in said image.

18. The apparatus of claim 16 wherein said multipole means is a sixteen pole circular array of arc-form electrodes preferably being adapted to introduce a parallel offset to said beam, the multipole means being a pair of successive sixteen pole circular arrays.

19. The apparatus of any of claims 1 - 5 further comprising a voltage adjustment device for variation of the lens voltages for fine-tuning the balance of distortion and blurring in said image.

20. The apparatus of claim 19 wherein said voltage adjustment device is further capable of disproportionate adjustment of said lens voltages for tuning said magnification of said image at said target.

21. The apparatus of any of the claims 1 - 5 in which the voltage on the first electrode of the gap lens is substantially the same as the voltage on the first and third electrodes of the Einzel lens and the voltage on the second electrode of the gap lens is substantially the same as the voltage on the second electrode of the Einzel lens whereby ripple effects on the power supply do not substantially alter the voltage ratio of the lens column thus substantially preserving the quality of the image at said target station.

22. The apparatus of any of the claims 1 - 5 constructed to enable the diameter of said gap lens to be changed to vary the magnification of said image at said target,
said beam emerging from said second lens, upon said change, remaining substantially telecentric and substantially free of chromatic aberration and geometric distortion at the image plane.

23. The apparatus of any of the claims 1 - 5 wherein said lens column includes an external, rigid metal shell which extends substantially the full length of said lens column, said shell being at constant potential and directly supporting the first and third electrode of said Einzel lens and the first electrode of said gap lens, the middle electrode of said Einzel lens being supported by insulators engaged for support upon the interior of the metal shell and the second electrode of said gap lens supported via an insulator bushing supported by the downstream end of said rigid shell.

24. The apparatus of claim 2, wherein a shield of high permeability magnetic material extends about said optical column.

25. The apparatus of claims 23 and 24 wherein the shield is supported by said rigid metal shell.

26. The apparatus of claim 24 or 25 wherein said shield is comprised of a series of removable longitudinal segments that define a tubular shield.

27. The apparatus of claim 26 wherein end plates of high permeability magnetic material are mounted at each end of said tubular shield in a manner to provide magnetic continuity with said tubular shield.

28. The apparatus of claim 26 wherein said tubular shield is defined by a set of longitudinally extending circumferentially spaced ribs mounted about said optical column, and a set of removable longitudinally extending side plates, each side plate spanning the gap between and in magnetic continuity with adjacent ribs.

**29.** The apparatus of any of the claims 24 through 28 including electrical conductors inside the shield arranged to provide adjustment to the magnetic field to which the ion beam is exposed.

**30.** The apparatus of claim 29 wherein said electrical conductors inside the shield comprise an array of elongated loops within said shield.

**31.** The apparatus of any of the claims 24 through 28 wherein an array of longitudinally extending electrically conductive loops is associated with said shield, said loops being arranged to establish magnetic flux in the circumferential direction in said tubular shield.

**32.** The apparatus of claim 31 including means to apply an alternating electrical current to the loops to demagnetize the shield and means to apply a momentary small bias current to the loops to increase the magnetic permeability of the shield.

**33.** The apparatus of claim 31 wherein each of said conductive loops comprises longitudinally extending conductive segments extending along the interior and the exterior of said tubular shield.

**34.** The apparatus of claims 31 through 33 including electrical conductors inside the shield arranged to provide adjustment to the magnetic field to which the ion beam is exposed.

**35.** The apparatus of claim 12 wherein said solenoid is a counterwound double solenoid adapted to prevent rotation of said ion beam during passage through said solenoid.

**36.** The apparatus of claim 12 or 35 further comprising an aperture located between said first and second lenses sized to prevent passage of ions differing in mass from the desired species.

**Patentansprüche**

**1.** Ionenprojektions-Lithografievorrichtung, umfassend:

Mittel zur Bereitstellung eines Ionenstrahls,
eine Maske im Pfad des genannten Ionenstrahls mit Blenden zur Erzeugung eines gewünschten Strahlenmusters,
eine Projektionssäule hinter der genannten Maske,
wobei die genannte Säule durch eine erste und eine zweite Hauptlinse definiert wird, die sich entlang des genannten Ionenpfades befinden,
wobei die genannte erste Linse so angeordnet ist, daß sie den genannten Ionenstrahl fokussiert, und eine beschleunigende Einzellinse ist, die so angeordnet ist, daß sie eine Überkreuzung in der genannten Säule bildet,
wobei die genannte zweite Linse hinter der Überkreuzung der genannten ersten Linse positioniert ist und eine Spaltlinse ist, die so angeordnet ist, daß sie ein verkleinertes Bild der genannten Maske projiziert, und
eine Objektstation hinter der genannten zweiten Linse zum Tragen eines Objekts, das das genannte Bild empfängt.

**2.** Vorrichtung nach Anspruch 1, bei der sich die genannte Maske im wesentlichen in der ersten Fokalebene der genannten ersten Linse und die genannte Objektstation im wesentlichen in der zweiten Fokalebene der genannten zweiten Linse befindet.

**3.** Vorrichtung nach Anspruch 2, bei der das genannte Mittel zur Bereitstellung des genannten Ionenstrahls eine Ionenquelle und ein Mittel umfaßt, um ein virtuelles Bild der genannten Ionenquelle auf der genannten Projektionssäule zu erzeugen, das weiter von der genannten Säule entfernt ist als die genannte Ionenquelle, und wobei die Abstände (1) zwischen der zweiten Fokalebene der genannten ersten Linse und der ersten Fokalebene der genannten zweiten Linse sowie (2) zwischen der genannten Maske und einem das virtuelle Bild der genannten Quelle und der genannten Maske definierenden Punkt so gewählt werden, daß das genannte Bild der genannten Maske an dem genannten Objekt entsteht, wobei von den genannten Linsen stammende chromatische Unschärfe und geometrische Verzerrung gleichzeitig im wesentlichen minimal gehalten werden.

4. Vorrichtung nach Anspruch 3, bei der die genannten Linsen so positioniert werden, daß sich die genannte Überkreuzung der genannten ersten Linse im wesentlichen in der ersten Fokalebene der genannten zweiten Linse befindet, um einen im wesentlichen telezentrischen Strahl hinter der genannten zweiten Linse zu erzeugen.

5. Ionenprojektions-Lithografiesystem nach Anspruch 1, bei dem das genannte Linsensystem gleichzeitig im wesentlichen die folgenden Bedingungen erfüllt, wonach der aus der zweiten Linse austretende Strahl im wesentlichen telezentrisch und beim Erreichen der Bildebene im wesentlichen frei von chromatischer Unschärfe und geometrischer Verzerrung ist;

$$(1) \qquad qp = f_1\, f_2$$

$$(2) \qquad \frac{(\delta_1/f_1)}{\left(\delta'_1/f'_1\right)} \cong \frac{p}{p+f_1}$$

$$(3) \qquad \frac{G(p)}{(D'/f'_1)} \cong \left(\frac{p}{f_2}\right)^3$$

wobei q der Abstand zwischen der zweiten Fokalebene der ersten Linse und der ersten Fokalebene der zweiten Linse ist,

p der Abstand zwischen einem Punkt, der das virtuelle Bild der genannten Quellen definiert, und der genannten Maske ist,

$f_1$ die erste Fokallänge der genannten ersten Linse ist,

$f_1'$ die erste Fokallänge der genannten zweiten Linse ist,

$f_2$ die zweite Fokallänge der genannten ersten Linse ist,

$\delta_1$ und $\delta_1'$ die Änderungen jeweils in der ersten Fokallänge der genannten ersten und der genannten zweiten Linse aufgrund einer Änderung der Energie der genannten Ionen in dem genannten Strahl sind,

$$G(p) = ap^3 + bp^2 + cp + d$$

wobei a, b, c und d Linsenkonstanten in bezug auf die Übertragungsfunktion von der ersten Fokalebene zu der zweiten Fokalebene der ersten Linse in Anwesenheit von Aberrationen dritter Ordnung sind, wobei die genannte Übertragungsfunktion die folgende Form hat:

$$\theta_2 = -r_1/f_2 + ar_1^3 + br_1^2\theta_1 + cr_1\theta_1^2 + d\theta_1^3$$

wobei $\theta_2$ die transformierte Querwinkelkoordinate eines bestimmten Ionenstrahls in der zweiten Fokalebene der genannten ersten Linse ist, $r_1$, $\theta_1$ die genannten Querkoordinaten in der ersten Fokalebene der genannten ersten Linse an der genannten Maske und D' ein Koeffizient bei der Transformation von der ersten Fokalebene auf die zweite Fokalebene der zweiten Linse sind;

$$r_2' = f_1'\, \theta_2 + D'\theta_2^3$$

wobei $r_2$ die Radialkoordinate des Strahls in der zweiten Fokalebene der zweiten Linse ist.

6. Vorrichtung nach einem der Ansprüche 1 bis 5 zur Bereitstellung von Ionen in dem genannten Ionenstrahl an dem genannten Objekt mit einer Energie zwischen etwa 50 und 200 kV.

7. Vorrichtung nach Anspruch 6 zur Bereitstellung von Ionen in dem genannten Ionenstrahl an der Maske mit einer Energie zwischen etwa 1 und 10 kV.

8. Vorrichtung nach einem der Ansprüche 1 bis 5, bei der das genannte Bild der genannten Maske an dem genannten Objekt um einen Faktor von 1,5 oder mehr verkleinert wird, wobei das genannte Bild an dem genannten Objekt eine Breite und eine Höhe von nicht weniger als 10 mm hat.

9. Vorrichtung nach einem der Ansprüche 1 bis 5, ferner umfassend ein Paar Feldregelungsblenden, von denen jeweils eine auf jeder Seite der zweiten Elektrode der genannten Einzellinse zum Reduzieren der von der genannten zweiten Elektrode stammenden elektrischen Feldstärke im Bereich um die genannte Maske und dem Bereich um die Blende der dritten Elektrode der genannten Einzellinse angeordnet ist.

10. Vorrichtung nach einem der Ansprüche 1 bis 5 zum Anlegen eines Spannungsverhältnisses im Bereich von 7 - 20 an die genannte erste und zweite Linse.

11. Vorrichtung nach einem der Ansprüche 1 bis 5, bei der das genannte Mittel zum Bereitstellen des genannten Ionenstrahls eine Ionenquelle und eine sich zwischen der genannten Ionenquelle und der genannten Maske befindliche Linse umfaßt, um den virtuellen Quellpunkt entlang der Achse der genannten Projektionssäule zu wählen, um das genannte System zum gleichzeitigen Minimieren von chromatischer Unschärfe und Linsenverzerrung feinabzustimmen.

12. Vorrichtung nach Anspruch 11, bei der die genannte Linse eine Magnetspule ist, wobei die genannte Magnetspule zur Auswahl der gewünschten Ionenspezies aus verschiedenen Spezies unterschiedlicher Massen beizutragen, die von den genannten Quelle mit unterschiedlicher Ablenkung der genannten Spezies je nach ihrer Masse ausgegeben wird.

13. Vorrichtung nach Anspruch 12, ferner umfassend eine Blende, die sich zwischen der genannten ersten und zweiten Linse befindet, um den Durchgang von Ionen zu verhindern, deren Masse sich von der der gewünschten Spezies unterscheidet.

14. Vorrichtung nach einem der Ansprüche 1 bis 5, ferner umfassend ein mehrpoliges Mittel, das sich in der genannten zweiten Linse oder dahinter befindet und vorzugsweise über ein Spannungsregelungssystem von Vierpolfeldern angewendet wird, um die Größe des Bildes an dem genannten Objekt in X-Richtung relativ zur Vergrößerung des Bildes in Y-Richtung zu verändern.

15. Vorrichtung nach Anspruch 14, bei der sich das genannte mehrpolige Mittel hinter der genannten zweiten Linse in einer von elektrischen Feldern im wesentlichen freien Zone befindet.

16. Vorrichtung nach einem der Ansprüche 1 bis 5, ferner umfassend ein mehrpoliges Mittel, das sich zwischen der genannten ersten und zweiten Linse befindet und Dipolfelder für eine verstellbare Bewegung des genannten Bildes in der Ebene lotrecht zur Achse der genannten Projektionssäule anlegt.

17. Vorrichtung nach Anspruch 16, bei der das genannte mehrpolige Mittel ferner überlagerte Felder höherer Ordnung zur Regelung von Verzerrung und Unschärfe in dem genannten Bild erzeugt.

18. Vorrichtung nach Anspruch 16, bei der das genannte mehrpolige Mittel eine 16-polige kreisförmige Anordnung von Bogenelektroden ist, die vorzugsweise einen Parallelversatz in den genannten Strahl einbringen, wobei das mehrpolige Mittel ein Paar aufeinanderfolgender 16-poliger kreisförmiger Anordnungen ist.

19. Vorrichtung nach einem der Ansprüche 1 bis 5, ferner umfassend eine Spannungsjustierungsvorrichtung zum Verändern der Linsenspannungen zum Feinabstimmen des Ausgleichs von Verzerrung und Unschärfe in dem genannten Bild.

20. Vorrichtung nach Anspruch 19, bei der die genannte Spannungsjustierungsvorrichtung ferner in der Lage ist, die genannten Linsenspannungen zum Abstimmen der genannten Größe des genannten Bildes an dem genannten Objekt disproportional zu verstellen.

21. Vorrichtung nach einem der Ansprüche 1 bis 5, bei der die Spannung an der ersten Elektrode der Spaltlinse im wesentlichen dieselbe ist wie die Spannung an der ersten und der dritten Elektrode der Einzellinse und die Spannung an der zweiten Elektrode der Spaltlinse im wesentlichen dieselbe ist wie die Spannung an der zweiten Elektrode der Einzellinse, so daß Welligkeitseffekte in der Stromversorgung das Spannungsverhältnis der Linsensäule nicht wesentlich ändern, so daß die Qualität des Bildes an der genannten Objektstation im wesentlichen erhalten bleibt.

**22.** Vorrichtung nach einem der Ansprüche 1 bis 5, die so aufgebaut ist, daß der Durchmesser der genannten Spaltlinse zum Verändern der Größe des genannten Bildes an dem genannten Objekt geändert werden kann,

wobei der genannte, aus der genannten zweiten Linse austretende Strahl nach der genannten Änderung im wesentlichen telezentrisch und im wesentlichen frei von chromatischen Aberrationen und geometrischer Verzerrung in der Bildebene bleibt.

**23.** Vorrichtung nach einem der Ansprüche 1 bis 5, bei der die genannte Linsensäule einen externen, starren Metallmantel beinhaltet, der im wesentlichen über die volle Länge der genannten Linsensäule verläuft, wobei der genannte Mantel ein konstantes Potential aufweist und unmittelbar die erste und dritte Elektrode der genannten Einzellinse und die erste Elektrode der genannten Spaltlinse trägt, wobei die mittlere Elektrode der genannten Einzellinse von Isolatoren getragen wird, die auf dem Inneren des Metallmantels aufliegen, und die zweite Elektrode der genannten Spaltlinse von einer Isolatorhülse getragen wird, die vom unterhalb gelegenen Ende des genannten starren Mantels getragen wird.

**24.** Vorrichtung nach Anspruch 2, bei der eine Abschirmung aus hochdurchlässigem Magnetmaterial um die genannte Projektionssäule verläuft.

**25.** Vorrichtung nach den Ansprüchen 23 und 24, bei der die Abschirmung auf dem genannten starren Metallmantel ruht.

**26.** Vorrichtung nach Anspruch 24 oder 25, bei der die genannte Abschirmung aus einer Reihe entfernbarer Längssegmente besteht, die eine röhrenförmige Abschirmung definieren.

**27.** Vorrichtung nach Anspruch 26, bei der Endplatten aus hochdurchlässigem Magnetmaterial an jedem Ende der genannten röhrenförmigen Abschirmung auf eine solche Weise montiert sind, daß ein magnetischer Durchgang mit der genannten röhrenförmigen Abschirmung entsteht.

**28.** Vorrichtung nach Anspruch 26, bei der die genannte röhrenförmige Abschirmung von einem Satz von in Längsrichtung verlaufenden, umfangsmäßig beanstandeten Rippen, die um die genannte Projektionssäule herum montiert sind, und einem Satz von entfernbaren, in Längsrichtung verlaufenden Seitenplatten definiert wird, wobei jede Seitenplatte den Spalt zwischen benachbarten Rippen und in magnetischem Durchgang mit diesen überspannt.

**29.** Vorrichtung nach einem der Ansprüche 24 bis 28, die elektrische Leiter in der Abschirmung aufweist, mit denen das Magnetfeld eingestellt werden kann, dem der Ionenstrahl ausgesetzt ist.

**30.** Vorrichtung nach Anspruch 29, bei der die genannten elektrischen Leiter in der Abschirmung eine Reihe von länglichen Schleifen in der genannten Abschirmung umfassen.

**31.** Vorrichtung nach einem der Ansprüche 24 bis 28, bei der eine Reihe von in Längsrichtung verlaufenden, elektrisch leitenden Schleifen mit der genannten Abschirmung assoziiert ist, wobei die genannten Schleifen so angeordnet sind, daß ein Magnetfluß in Umfangsrichtung in der genannten röhrenförmigen Abschirmung entsteht.

**32.** Vorrichtung nach Anspruch 31 mit einem Mittel zum Zuführen eines Wechselstroms zu den Schleifen, um die Abschirmung zu entmagnetisieren, und ein Mittel zum Zuführen eines kurzzeitigen kleinen Vorstroms zu den Schleifen, um die magnetische Durchlässigkeit der Abschirmung zu erhöhen.

**33.** Vorrichtung nach Anspruch 31, bei der jede der genannten leitenden Schleifen in Längsrichtung verlaufende leitende Segmente umfaßt, die über das Innere und das Äußere der genannten röhrenförmigen Abschirmung verlaufen.

**34.** Vorrichtung nach Anspruch 31 bis 33, die elektrische Leiter in der Abschirmung aufweist, mit denen das Magnetfeld eingestellt werden kann, dem der Ionenstrahl ausgesetzt ist.

**35.** Vorrichtung nach Anspruch 12, bei der die genannte Magnetspule eine gegengewickelte doppelte Magnetspule ist, die die eine Rotation des genannten Ionenstrahls während des Durchgangs durch die genannte Magnetspule verhindert.

**36.** Vorrichtung nach Anspruch 12 oder 35, ferner umfassend eine Blende, die sich zwischen der genannten ersten und zweiten Linse befindet und so bemessen ist, daß sie den Durchgang von Ionen verhindert, deren Masse sich von der der gewünschten Spezies unterscheidet.

## Revendications

**1.** Appareil de lithographie à projection d'ions comprenant :

des moyens pour fournir un faisceau d'ions,
un masque dans le trajet dudit faisceau d'ions, muni d'ouvertures pour produire un motif de faisceau souhaité,
une colonne optique après ledit masque,
ladite colonne étant définie par des première et seconde lentilles situées le long dudit trajet des ions,
ladite première lentille étant conçue pour focaliser ledit faisceau d'ions et étant une lentille d'accélération d'Einzel conçue pour former un croisement à l'intérieur de ladite colonne,
ladite seconde lentille étant positionnée après le croisement de ladite première lentille et étant une lentille d'espacement, conçue pour projeter une image réduite dudit masque,
et
un poste de cible après ladite seconde lentille pour supporter une cible qui reçoit ladite image.

**2.** Appareil selon la revendication 1, dans lequel ledit masque est situé sensiblement au niveau du premier plan focal de ladite première lentille, et ledit poste de cible est situé sensiblement au niveau du second plan focal de ladite seconde lentille.

**3.** Appareil selon la revendication 2, dans lequel lesdits moyens pour réaliser ledit faisceau d'ions comprennent une source d'ions et des moyens pour donner à ladite colonne optique une image virtuelle de ladite source d'ions plus distante de ladite colonne que ladite source d'ions, et les distances (1) entre le second plan focal de ladite première lentille et le premier plan focal de ladite seconde lentille, et (2) entre ledit masque et un point définissant l'image virtuelle de ladite source et dudit masque, étant sélectionnées pour produire ladite image dudit masque au niveau de ladite cible, le flou chromatique et la déformation géométrique provenant desdites lentilles étant sensiblement minimisés en même temps.

**4.** Appareil selon la revendication 3, dans lequel lesdites lentilles sont positionnées pour localiser ledit croisement de ladite première lentille sensiblement au niveau du premier plan focal de ladite seconde lentille pour produire un faisceau sensiblement télécentrique suivant ladite seconde lentille.

**5.** Système de lithographie à projection d'ions selon la revendication 1, dans lequel ledit système de lentilles satisfait sensiblement en même temps les conditions suivantes de sorte que le faisceau émergeant de la seconde lentille est sensiblement télécentrique et quand il atteint le plan d'image, il est sensiblement exempt de flou chromatique et de déformation géométrique ;

$$(1) \qquad qp = f_1\, f_2$$

$$(2) \qquad \frac{(\delta_1/f_1)}{\delta'_1/f'_1} \cong \frac{p}{p + f_1}$$

$$(3) \qquad \frac{G(p)}{(D'/f'_1)} \cong \left(\frac{p}{f_2}\right)^3$$

où q est la distance entre le second plan focal de la première lentille et le premier plan focal de la seconde lentille,
p est la distance entre un point définissant l'image virtuelle de ladite source et dudit masque,
$f_1$ est la première longueur focale de ladite première lentille,
$f_1'$ est la première longueur focale de ladite seconde lentille,
$f_2$ est la seconde longueur focale de ladite première lentille,

$\delta_1$ et $\delta_1$' sont les modifications de la première longueur focale respectivement de ladite première lentille et de ladite seconde lentille, à cause d'une modification de l'énergie desdits ions dans ledit faisceau,

$$G(p) = ap^3 + bp^2 + cp + d$$

où a, b, c et d sont des constantes de lentille se rapportant à la fonction de transfert depuis le premier plan focal vers le second plan focal de la première lentille, en présence d'aberrations de troisième ordre, ladite fonction de transfert étant de la forme :

$$\theta_2 = -r_1 / f_2 + ar^3_1 + br^2_1\theta_1 + cr_1\theta^2_1 + d\theta^3_1$$

où $\theta_2$ est la coordonnée angulaire transversale transformée d'un rayon ionique donné au niveau du second plan focal de ladite première lentille, $r_1$, $\theta_1$ sont lesdites coordonnées transversales au niveau du premier plan focal de ladite première lentille au niveau dudit masque et D' est un coefficient dans la transformation allant du premier plan focal vers le second plan focal de la seconde lentille ;

$$r_2' = f_1'\theta_2 + D'\theta_2^3$$

où $r_2$ est la coordonnée radiale du rayon au niveau du second plan focal de la seconde lentille.

6.  Appareil selon l'une quelconque des revendications 1 à 5, conçu pour donner des ions dans ledit faisceau d'ions au niveau de ladite cible à une énergie comprise entre environ 50 et 200 kV.

7.  Appareil selon la revendication 6 conçu pour donner des ions dans ledit faisceau d'ions au niveau du masque à une énergie comprise entre environ 1 et 10 kV.

8.  Appareil selon l'une quelconque des revendications 1 à 5, dans lequel ladite image dudit masque au niveau de ladite cible est réduite d'un facteur de 1,5 ou plus, ladite image au niveau de ladite cible n'étant pas inférieure à 10 mm en largeur et en hauteur.

9.  Appareil selon l'une quelconque des revendications 1 à 5, comprenant de plus un couple d'ouvertures à commande de champ, une disposée de chaque côté de la deuxième électrode de ladite lentille d'Einzel pour réduire l'intensité du champ électrique provenant de ladite deuxième électrode dans la zone autour dudit masque et dans la zone autour de l'ouverture de la troisième électrode de ladite lentille d'Einzel.

10. Appareil selon l'une quelconque des revendications 1 à 5, conçu pour appliquer un rapport de tension dans la plage de 7 à 20 auxdites première et seconde lentilles.

11. Appareil selon l'une quelconque des revendications 1 à 5, dans lequel lesdits moyens pour réaliser ledit faisceau d'ions comprennent une source d'ions et une lentille située entre ladite source d'ions et ledit masque pour sélectionner le point de source virtuelle le long de l'axe de ladite colonne optique pour accorder finement ledit système pour minimiser en même temps le flou chromatique et la déformation de lentille.

12. Appareil selon la revendication 11, dans lequel ladite lentille est un solénoïde, ledit solénoïde étant conçu pour contribuer à la sélection des espèces d'ions souhaitées à partir de différentes espèces de masses différentes issues de ladite source par une déviation différentielle desdites espèces selon leur masse.

13. Appareil selon la revendication 12 comprenant de plus une ouverture située entre lesdites première et seconde lentilles pour empêcher le passage d'ions de masse différente de celle des espèces souhaitées.

14. Appareil selon l'une quelconque des revendications 1 à 5, comprenant de plus des moyens multipolaires situés à l'intérieur de ladite seconde lentille ou au-delà de cette dernière pour l'application, de préférence via un système de commande de tension, de champs quadripolaires pour modifier l'agrandissement de l'image au niveau de ladite cible dans la direction X par rapport à l'agrandissement de l'image dans la direction Y.

15. Appareil selon la revendication 14, dans lequel lesdits moyens multipolaires sont situés après ladite seconde lentille dans une zone sensiblement exempte de champs électriques.

16. Appareil selon l'une quelconque des revendications 1 à 5, comprenant de plus des moyens multipolaires situés entre lesdites première et seconde lentilles, conçus pour appliquer des champs bipolaires pour le déplacement réglable de ladite image dans le plan perpendiculaire à l'axe de ladite colonne optique.

17. Appareil selon la revendication 16, dans lequel lesdits moyens multipolaires sont conçus de plus pour produire des champs superposés d'ordre supérieur pour maîtriser la déformation et le flou de ladite image.

18. Appareil selon la revendication 16, dans lequel lesdits moyens multipolaires sont un groupement circulaire à seize pôles d'électrodes en forme d'arc conçues, de préférence, pour introduire un décalage parallèle dudit faisceau, les moyens multipolaires étant un couple de groupements circulaires successifs de seize pôles.

19. Appareil selon l'une quelconque des revendications 1 à 5, comprenant de plus un dispositif de réglage de tension pour modifier les tensions de lentille pour l'accord fin de l'équilibre de déformation et de flou de ladite image.

20. Appareil selon la revendication 19, dans lequel ledit dispositif de réglage de tension est capable, de plus, d'un réglage disproportionné desdites tensions de lentille pour accorder ledit agrandissement de ladite image au niveau de ladite cible.

21. Appareil selon l'une quelconque des revendications 1 à 5, dans lequel la tension sur la première électrode de la lentille d'espacement est sensiblement la même que la tension sur les première et troisième électrodes de la lentille d'Einzel, et la tension sur la seconde électrode de la lentille d'espacement est sensiblement la même que la tension sur la deuxième électrode de la lentille d'Einzel de sorte que des effets d'ondulation de l'alimentation en courant n'altèrent sensiblement pas le rapport de tension de la colonne de lentilles, préservant ainsi sensiblement la qualité de l'image au niveau dudit poste de cible.

22. Appareil selon l'une quelconque des revendications 1 à 5, construit pour permettre la modification du diamètre de ladite lentille d'espacement pour modifier l'agrandissement de ladite image au niveau de ladite cible,
ledit faisceau émergeant de ladite seconde lentille, lors de ladite modification, restant sensiblement télécentrique et sensiblement exempt d'aberration chromatique et de déformation géométrique au niveau du plan d'image.

23. Appareil selon l'une quelconque des revendications 1 à 5, dans lequel ladite colonne de lentilles comprend une coque métallique rigide externe qui s'étend sensiblement sur la totalité de la longueur de ladite colonne de lentilles, ladite coque étant à un potentiel constant et supportant directement les première et troisième électrodes de ladite lentille d'Einzel et la première électrode de ladite lentille d'espacement, l'électrode du milieu de ladite lentille d'Einzel étant supportée par des isolateurs en contact pour un support sur l'intérieur de la coque métallique, et la seconde électrode de ladite lentille d'espacement étant supportée via une douille formant isolateur supportée par l'extrémité aval de ladite coque rigide.

24. Appareil selon la revendication 2, dans lequel un blindage de matière magnétique à perméabilité élevée s'étend autour de ladite colonne optique.

25. Appareil selon les revendications 23 et 24, dans lequel le blindage est supporté par ladite coque métallique rigide.

26. Appareil selon la revendication 24 ou 25, dans lequel ledit blindage est constitué par une série de segments longitudinaux amovibles qui définissent un blindage tubulaire.

27. Appareil selon la revendication 26, dans lequel des plaques d'extrémité de matière magnétique à perméabilité élevée sont montées au niveau de chaque extrémité dudit blindage tubulaire de manière à réaliser une continuité magnétique avec ledit blindage tubulaire.

28. Appareil selon la revendication 26, dans lequel ledit blindage tubulaire est défini par un jeu de nervures espacées sur la circonférence s'étendant de manière longitudinale, montées autour de ladite colonne optique, et un jeu de plaques latérales amovibles s'étendant de manière longitudinale, chaque plaque latérale enjambant l'espacement entre les nervures adjacentes et en continuité magnétique avec ces dernières.

29. Appareil selon l'une quelconque des revendications 24 à 28, comprenant des conducteurs électriques à l'intérieur du blindage, conçus pour réaliser l'ajustement du champ magnétique auquel le faisceau d'ions est exposé.

30. Appareil selon la revendication 29, dans lequel lesdits conducteurs électriques à l'intérieur du blindage comprennent un groupement de boucles allongées à l'intérieur dudit blindage.

31. Appareil selon l'une quelconque des revendications 24 à 28, dans lequel un groupement de boucles électriquement conductrices s'étendant de manière longitudinale est associé audit blindage, lesdites boucles étant conçues pour établir un flux magnétique dans la direction circonférentielle dans ledit blindage tubulaire.

32. Appareil selon la revendication 31, comprenant des moyens pour appliquer un courant électrique alternatif aux boucles pour démagnétiser le blindage, et des moyens pour appliquer un petit courant momentané de polarisation aux boucles pour augmenter la perméabilité magnétique du blindage.

33. Appareil selon la revendication 31, dans lequel chacune desdites boucles conductrices comprend des segments conducteurs s'étendant de manière longitudinale, s'étendant le long de l'intérieur et de l'extérieur dudit blindage tubulaire.

34. Appareil selon les revendications 31 à 33, comprenant des conducteurs électriques à l'intérieur du blindage conçus pour réaliser l'ajustement du champ magnétique auquel le faisceau d'ions est exposé.

35. Appareil selon la revendication 12, dans lequel ledit solénoïde est un solénoïde double enroulé en sens opposé, conçu pour empêcher la rotation dudit faisceau d'ions pendant le passage à travers ledit solénoïde.

36. Appareil selon la revendication 12 ou 35, comprenant de plus une ouverture située entre lesdites première et seconde lentilles, dimensionnée pour empêcher le passage d'ions de masse différente de celle des espèces souhaitées.

FIG.1

EP 0 344 646 B1

FIG. la

FIG. Ib

FIG. Ic

EP 0 344 646 B1

FIG. 2

EP 0 344 646 B1

FIG.2a

FIG. 2b

FIG. 3

FIG. 2c

FIG. 7

FIG.4

EP 0 344 646 B1

FIG.5

36

Region of
Barrel
Distortion

Region of Pin Cushion
Distortion

Position Free
of Distortion

Mask

Virtual
Source

1st Lens

2nd Lens

Barrel
Distortion

Pin Cushion
Distortion

Desired
Image

FIG.6

FIG.8